# EUROPEAN PATENT APPLICATION

(11) **EP 0 703 605 A2**
(43) Date of publication of application: **27.03.1996**
(21) Application number: 95113480.8
(22) Date of filing: 28.08.1995
(51) Int. Cl.: H01L 21/306, H01L 21/20, H01S 3/19

(54) **Method for etching semiconductor, method for fabricating semiconductor device, method for fabricating semiconductor laser, and semiconductor laser**

(30) Priority: 02.09.1994 JP 19940209980
(71) Applicant: MITSUBISHI DENKI KABUSHIKI KAISHA, Tokyo 100 (JP)
(72) Inventor: Motoda, Takashi, c/o Mitsubishi Denki K.K., 1 Mizuhara 4-chome, Itami-shi, Hyogo 664 (JP); Kato, Manabu, c/o Mitsubishi Denki K.K., 1 Mizuhara 4-chome, Itami-shi, Hyogo 664 (JP); Takemi, Masayoshi, c/o Mitsubishi Denki K.K., 1 Mizuhara 4-chome, Itami-shi, Hyogo 664 (JP)
(74) Representative: KUHNEN, WACKER & PARTNER

(57) **Abstract**

An etching method for semiconductor comprises: etching a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor. Therefore, an etching method that can perform an etching having higher controllability than the wet etching is provided. In addition, because no etching solution is employed, an etching method that can be employed in a crystal growth apparatus can be provided. Further, because material gas of a III-V group compound semiconductor layer is employed as an etching gas, residual of impurities other than the material of the III-V group compound semiconductor layer at the etched surface can be prevented, thereby keeping the etched surface cleanly.

## Description

### FIELD OF THE INVENTION

The present invention relates to a method for etching semiconductor, a method for fabricating a semiconductor device, a method for fabricating a semiconductor laser, and a semiconductor laser. More particularly, the invention relates to a method for etching a III-V group compound semiconductor, a method for fabricating a semiconductor device and a method for fabricating a semiconductor device employing the semiconductor etching method, and a semiconductor laser fabricated employing the semiconductor etching method.

### BACKGROUND OF THE INVENTION

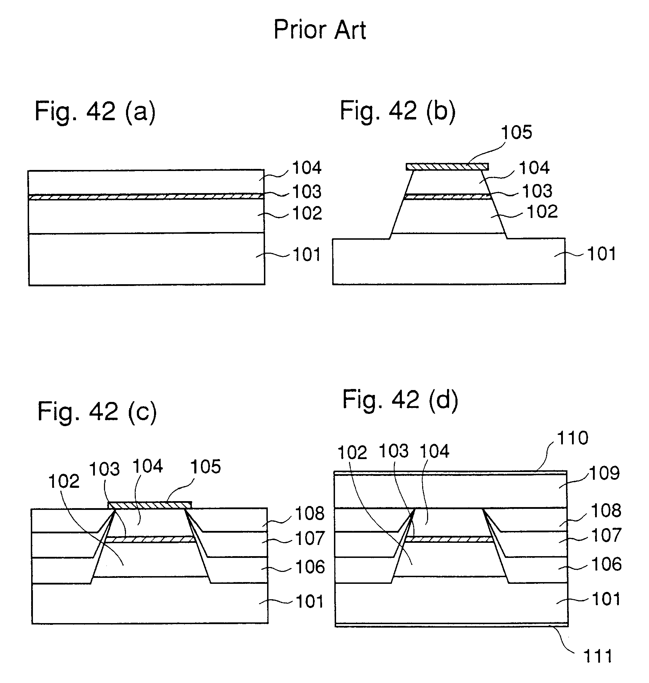

Figures 42(a)-42(d) are diagrams illustrating a process of the method for fabricating a semiconductor laser for explaining a prior art method for etching a semiconductor. In the figures, reference numeral 101 designates p type InP substrate. Numeral 102 designates a p type InP cladding layer. Numeral 103 designates an InGaAsP active layer. Numeral 104 designates an n type InP cladding layer. Numeral 105 designates an insulating film. Numeral 106 designates a first n type InP blocking layer. Numeral 107 designates a p type InP blocking layer. Numeral 108 designates a second n type InP blocking layer. Numeral 109 designates a p type InP contact layer. Numeral 110 designates an n side electrode. Numeral 111 designates a p side electrode.

A description is given of the method for fabricating the prior art semiconductor laser. First of all, in the step of figure 42(a), on a p type InP substrate 101, a p type cladding layer 102, an active layer 103, and an n type cladding layer 104 are successively crystalline grown in the MOCVD (metal organic chemical vapor deposition) apparatus. Next, the wafer is taken out from the MOCVD apparatus, a stripe shaped insulating film 105 is formed on the n type cladding layer 104, the wafer is etched in liquid phase from the surface of the n type cladding layer 104 up to reaching the p type InP substrate 101 using the insulating film 105 as a mask by bromo-methanol mixture etchant or sulfuric acid series etchant, thereby forming a mesa-stripe configuration as shown in figure 42(b). Further, in the step of figure 42(c), the wafer is returned into the MOCVD apparatus, and the n type InP blocking layer 106, the p type InP blocking layer 107, and the second n type InP blocking layer 108 are selectively regrown so as to bury the mesa-stripe. Thereafter, the wafer is taken out from the MOCVD apparatus, the insulating film 105 is removed, the wafer is again returned into the MOCVD apparatus and a contact layer 109 is formed on the mesa-stripe and the second n type n type InP blocking layer 108. Further, an n side electrode 110 is formed on the surface of the contact layer 109 by evaporation and a p side electrode 111 is formed on the rear surface of the substrate 101, thereby forming a semiconductor laser as shown in figure 42(d).

As described above, as a prior art etching method for compound semiconductor, a liquid phase etching using bromo-methanol mixture or sulfuric acid series etchant are performed, and the control of the etching rate is quite difficult and the control of the etching remaining thickness was quite difficult.

In addition, because the etching is carried out by using the etching solution, it may arise variations in the etching dependent on the position on the wafer and the controllability of etching was difficult.

In addition, carrying out the etching and regrowth of compound semiconductor successively in the MOCVD apparatus in order to make the oxidation of regrowth interface and attachment of impurities dispensed with is recently studied in the fabrication process of a semiconductor device, it was difficult to apply the conventional liquid phase etching to etching a semiconductor layer in a semiconductor crystal growth apparatus such as an MOCVD apparatus in view of the structure of apparatus.

### SUMMARY OF THE INVENTION

It is an object of the present invention to provide an etching method for compound semiconductor that can etch a semiconductor laser with high controllability not using etching solution.

Another object of the present invention is to provide a fabricating method of a semiconductor device and a fabricating method of a semiconductor laser each using the above-described etching method.

A still another object of the present invention is to provide a semiconductor laser that is fabricated by using the above-described etching method.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, an etching method for semiconductor comprises:
etching a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor.

Therefore, an etching method that can perform an etching having higher controllability than the wet etching is provided. In addition, because no etching solution is employed, an etching method that can be employed in a crystal growth apparatus can be provided. Further, because material gas of a III-V group compound semiconductor layer is employed as an etching gas, residual of impurities other than the material of the III-V group compound semiconductor layer at the etched surface can be prevented, thereby keeping the etched surface cleanly.

According to a second aspect of the present invention, in the above-described etching method, the III group gas forming said III-V group compound semiconductor layer is added to said etching gas thereby to control the etching characteristics of said etching.

Therefore, a desired etching configuration can be easily obtained.

According to a third aspect of the present invention, in the above-described etching method, said III-V group compound semiconductor layer is an InP layer, and said etching is carried out by using a gas including phosphorus gas.

Therefore, an etching with high controllability can be performed.

According to a fourth aspect of the present invention, in the above-described etching method, said III-V group compound semiconductor layer is an InP layer, and said etching is carried out by keeping said InP layer at above 700 °C.

Therefore, an etching with high controllability can be performed.

According to a fifth aspect of the present invention, in the above-described etching method, said III-V group semiconductor layer is an InP layer, and said etching is carried out by keeping said InP layer at above 700 °C, using PH₃ gas of flow rate of 400 SCCM and H₂ gas of flow rate of 25 SCCM as etching gases and keeping the pressure in the reaction apparatus at a 30 Torr.

Therefore, an etching with high controllability can be performed.

According to a sixth aspect of the present invention, in the above-described etching method, it further comprises:
forming an insulating film provided with a stripe shaped aperture comprising a plurality of regions having different aperture widths on a main surface of said III-V group compound semiconductor layer; and
selectively etching said III-V group compound semiconductor layer using said insulating film as a mask.

Therefore, an etching with high controllability can be performed as well as an etching having a shallow depth in the region having the wide aperture width and a deep depth in the region having a narrow aperture width can be simultaneously performed.

According to a seventh aspect of the present invention, in the above-described etching method, it further comprises:
forming an insulating film provided with a stripe shaped aperture of a predetermined width and having a plurality of regions having different widths in the stripe direction of said aperture portion;
selectively etching said III-V group compound semiconductor layer using said insulating film as a mask.

Therefore, an etching having a deep depth in the aperture in the region of the insulating film having a wide width and a shallow depth in the aperture in the region of the insulating film having a narrow width can be simultaneously performed.

According to an eighth aspect of the present invention, in the above-described etching method, an etching method for semiconductor comprises:
selectively etching only a prescribed region of the surface of said III-V group compound semiconductor layer with keeping said III-V group compound semiconductor layer under an ambient where an etching gas including V group gas constituting said III-V group compound semiconductor layer is supplied and heating said prescribed region.

Therefore, an etching with high controllability can be performed without employing a selective mask.

According to a ninth aspect of the present invention, in the above-described etching method, said etching is carried out with holding said III-V group compound semiconductor layer at a temperature at which crystal growth of said III-V group compound semiconductor is possible.

Therefore, a selective etching and a selective regrowth can be simultaneously performed.

According to a tenth aspect of the present invention, in the above-described etching method, it further comprises:
forming an insulating film having an aperture on a main surface of a III-V group compound semiconductor layer;
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor; and
growing another semiconductor layer using said insulating film as a mask with replacing the etching gas used for said etching by a crystal growth gas without said III-V group compound semiconductor layer being exposed to the external air.

Therefore, after performing an etching with high controllability without employing etching solution, the other semiconductor layer can be regrown successively and a semiconductor device having a superior characteristics having a clean regrowth interface with less impurities such as oxide film can be offered.

According to an eleventh aspect of the present invention, in the above-described etching method, a method for fabricating a semiconductor device, comprises:
forming an insulating film having an aperture on a main surface of a first conductivity type III-V group compound semiconductor layer;
selectively etching said first conductivity type IIIV group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said IIIV group compound semiconductor; and
selectively growing a double-hetero structure comprising a first conductivity type cladding layer, an active layer, and a second conductivity type cladding layer successively using said insulating film as a mask with replacing the etching gas used for said etching by a crystal growth gas without said III-V group compound semiconductor layer being exposed to the external air.

Therefore, a semiconductor laser having a superior characteristics in which the active layer is in parallel with a main surface of the first conductivity type III-V group compound semiconductor layer can be provided with high reproducibility.

According to a twelfth aspect of the present invention, in the above-described etching method, a method for fabricating a semiconductor device, comprises:
forming an insulating film having an aperture on a main surface of a III-V group compound semiconductor layer;
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor; and
selectively growing a multi-quantum well structure layer using said insulating film as a mask with replacing the etching gas used for said etching by a crystal growth gas without said III-V group compound semiconductor layer being exposed to the external air.

Therefore, a quantum well structure layer having a thin thickness in the region having the wide aperture width, having a thick thickness in the region having the narrow aperture width, and having an equal height with respect to a main surface of said III-V group compound semiconductor layer. For example, when it is applied to the fabrication of an integrated semiconductor laser and light modulator, the height of the multi-quantum well structure layer at the region having the narrow aperture width which is to be a semiconductor laser region and the height of the multi-quantum well structure layer at the region having the wide aperture region which is to be a light modulator region can be aligned, whereby an integrated semiconductor laser and light modulator superior in the laser light propagating property is obtained.

According to a thirteenth aspect of the present invention, a method for fabricating a semiconductor device, comprises:
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor.

Therefore, a semiconductor device provided with a diffraction grating structure can be produced with high reproducibility.

According to a fourteenth aspect of the present invention, in the above-described etching method, said plurality of stripe shaped apertures have a stripe length for a prescribed region different from the stripe length of other region.

Therefore, a diffraction grating structure provided with a diffraction grating groove having different depths, i.e., having a shallow depth in the region having a long stripe length and a deep depth in the region having a short stripe length can be formed simultaneously.

According to a fifteenth aspect of the present invention, in the above-described etching method, said plurality of stripe shaped apertures have stripe lengths mutually equal to each other, and
said insulating film is formed to have a width in the direction perpendicular to the arranging direction of said apertures that is narrower than the width of the other region.

Therefore, a diffraction grating structure provided with a diffraction grating groove having different depths, i.e., having a deep depth in the region having a wide insulating film width and a deep depth in the region having a narrow insulating film width can be formed simultaneously.

According to a sixteenth aspect of the present invention, in the above-described etching method, further comprises:
after selectively etching said III-V group compound semiconductor layer, growing another semiconductor layer using said insulating film with replacing the etching gas by a crystal growth gas without said III-V group compound semiconductor layer being exposed to the external air.

Therefore, a semiconductor device provided with a diffraction grating structure that has regrown the other semiconductor layer in the diffraction grating groove so that the regrowth interface become clean can be provided. For example, when it is applied to a DFB (distributed feedback laser), a DFB laser that has less loss due to impurities in the regrowth surface of the diffraction grating and having a superior laser characteristics is obtained.

According to a seventeenth aspect of the present invention, a method for fabricating a semiconductor layer, comprises:
forming a current blocking layer comprising a IIIV group compound semiconductor material on a main surface of a first conductivity type III-V group compound semiconductor substrate;
forming an insulating film having a stripe shaped aperture on the surface of said current blocking layer;
forming a stripe shaped groove by selectively etching said current blocking layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a stripe shaped groove; and
selectively growing a double-hetero structure comprising a first conductivity type cladding layer, an active layer, and a second conductivity type cladding layer using said insulating film as a mask with replacing said etching gas used for said etching without the surface of said stripe shaped groove being exposed to the outside air.

Therefore, a stripe shaped groove can be formed in the current blocking layer with high controllability and a semiconductor laser having a desired configuration can be produced with high reproducibility. In addition, the regrowth surface of the stripe shaped groove can be made clean, and a semiconductor laser with superior characteristics can be provided.

According to an eighteenth aspect of the present invention, in the above-described etching method, a method for fabricating a semiconductor laser, comprises:
forming a double-hetero structure comprising a first conductivity type cladding layer, an active layer, and a second conductivity type cladding layer on a main surface of a first conductivity type III-V group compound semiconductor substrate;
forming a stripe shaped insulating film on said double-hetero structure, and forming a mesa stripe by selectively etching said double-hetero structure up to reaching said substrate using said insulating film as a mask by an etching method for semiconductor, that etches a III-V group compound semiconductor using an etching gas including V group material forming said IIIV group compound semiconductor layer and keeping said III-V group compound semiconductor layer at a temperature higher than the temperature of the crystal growth temperature of said III-V group compound semiconductor, to form a mesa stripe; and
selectively growing a current blocking layer so as to bury said mesa-stripe, using said insulating film as a mask with replacing said etching gas used for said etching without the surface of said stripe shaped groove being exposed to the outside air.

Therefore, the double hetero structure can be etched into a mesa stripe configuration with high controllability and a semiconductor laser with a desired configuration can be provided with high reproducibility. In addition, the regrowth interface of the side of the mesa-stripe and the surface of the semiconductor substrate can be made clean and a semiconductor laser having a superior characteristics is obtained.

According to a seventeenth aspect of the present invention, in the above-described etching method, a method for fabricating a semiconductor laser, comprises:
forming a current blocking layer comprising a IIIV group semiconductor material on a main surface of a first conductivity type III-V group compound semiconductor substrate;
forming an insulating film having a plurality of stripe shaped apertures mutually parallel and having a different aperture width on the surface of the current blocking layer;
forming a stripe shaped grooves by selectively etching said current blocking layer up to reaching said substrate using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a plurality of stripe shaped grooves; and
selectively growing a double-hetero structure comprising a first conductivity type cladding layer, a multi-quantum well structure active layer, and a second conductivity type cladding layer, using said insulating film as a mask with replacing said etching gas used for said etching without the surface of said stripe shaped groove being exposed to the outside air.

Therefore, it is possible to form simultaneously a double hetero structure provided with a thin thickness multi-quantum well structure active layer in the stripe shaped groove corresponding to the wide aperture width and a double hetero structure provided with a thick thickness multi-quantum well structure active layer in the stripe shaped groove corresponding to the narrow aperture width, and an array type semiconductor laser provided with a plurality of laser elements having different oscillation wavelengths at one time and the fabrication process can be shortened.

According to a twentieth aspect of the present invention, a method for fabricating a semiconductor laser device, comprises:
forming a first insulating film having a plurality of striped shaped apertures mutually parallel having different aperture widths on a main surface of a first conductivity type III-V group compound semiconductor substrate;
selectively etching said III-V group compound semiconductor substrate using said first insulating film as a mask by an etching method for semiconductor, that etches a III-V group compound semiconductor using an etching gas including V group material forming said IIIV group compound semiconductor layer and keeping said III-V group compound semiconductor layer at a temperature higher than the temperature of the crystal growth temperature of said III-V group compound semiconductor, to form a plurality of stripe shaped grooves;
selectively growing a double-hetero structure comprising a first conductivity type cladding layer, a multi-quantum well structure active layer, and a second conductivity type cladding layer, using said first insulating film as a mask with replacing said etching gas used for said etching without the surface of said stripe shaped groove being exposed to the outside air, so as to bury said plurality of stripe shaped grooves; and
after removing said first insulating film, forming a stripe shaped second insulating film extending in the length direction of said double-hetero structure on said double-hetero structure, and etching said double-hetero structure using said second insulating film as a mask, thereby to form a mesa-stripe; and
forming a current blocking layer so as to bury said mesa-stripe using said second insulating film as a mask.

Therefore, it is possible to form simultaneously a mesa-stripe comprising a double hetero structure provided with a thin thickness multi-quantum well structure active layer in the region corresponding to the wide aperture width and a mesa-stripe comprising a double hetero structure provided with a thick thickness multi-quantum well structure active layer in the region corresponding to the narrow aperture width, and an array type semiconductor laser provided with a plurality of laser elements having different oscillation wavelengths at one time and the fabrication process can be shortened.

According to a twenty-first aspect of the present invention, a method for fabricating a semiconductor laser, comprises:
forming an insulating film having a stripe shaped aperture on a main surface of a first semiconductor layer comprising a III-V group compound semiconductor;
selectively etching said III-V group compound semiconductor substrate using said stripe shaped insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said IIIV group compound semiconductor, to form a plurality of stripe shaped grooves;
selectively growing an electron running layer at the bottom of said stripe shaped groove using said insulating film with replacing said etching gas by crystal growth gas without the surface of said stripe shaped V shaped groove being exposed to the external air; and
after said selective growth, selectively growing a second III-V group compound semiconductor layer comprising the same material as that of said first semiconductor layer so as to bury said stripe shaped V shaped groove using said insulating film.

Therefore, a semiconductor device having a quantum wire structure can be provided with high reproducibility. In addition, the quantum wire structure can be formed so that the periphery of the electron running layer is made clean and a semiconductor device provided with a superior characteristics is obtained.

According to a twenty-second aspect of the present invention, a method for fabricating a semiconductor device, comprises:
forming an electron running layer comprising an intrinsic semiconductor layer and a second semiconductor layer comprising an intrinsic III-V group compound semiconductor layer electron running layer on a main surface of a first semiconductor layer;
forming an insulating film having a stripe shaped aperture on the surface of said second semiconductor layer;
etching said second semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor up to a depth not reaching said electron running layer, to form a stripe shaped V-shaped groove;
selectively growing a third III-V group compound semiconductor layer having a prescribed conductivity type comprising the same material as that of said first semiconductor layer so as to bury said V-shaped groove using said insulating film with replacing said etching gas by crystal growth gas without the surface of said second semiconductor layer being exposed to the external air.

Therefore, a quantum wire structure can be obtained with high reproducibility. In addition, the quantum wire structure can be formed so that the regrowth surface of the V shaped groove is made clean and a semiconductor device provided with superior characteristic is obtained.

According to a twenty-third aspect of the present invention, a semiconductor laser comprises:
a III-V group compound semiconductor layer having a groove on its main surface comprising a plurality of regions having different aperture widths and the depth of the wide aperture width region is deeper than the depth of the narrow aperture width region;
a double-hetero structure layer including a multi-quantum well structure layer formed so as to bury said stripe shaped groove, having a thickness thinner than the thickness of the narrow aperture width region in the wide aperture width region and having a height with relative to the main surface of the III-V group compound semiconductor layer which is equal over the entire surface.

Therefore, when, for example, it is applied to an integrated semiconductor laser and light modulator, it is possible to align the height of the multi-quantum well structure layer as a light emission part of the semiconductor laser region and the multi-quantum well structure layer of the light modulator region and an integrated semiconductor laser and light modulator superior in the propagation property of the laser light is provided.

According to a twenty-fourth aspect of the present invention, a semiconductor laser, comprises:
a first conductivity type III-V group compound semiconductor substrate;
a current blocking layer comprising a III-V group compound semiconductor material formed on a main surface of said first conductivity type III-V group compound semiconductor substrate;
a plurality of stripe shaped grooves formed by forming a plurality of stripe shaped apertures having different aperture widths and mutually parallel on the surface of the current blocking layer and selectively etching said current blocking layer using said insulating film as a mask by an etching method for semiconductor, that etches a III-V group compound semiconductor using an etching gas including V group material forming said IIIV group compound semiconductor layer and keeping said III-V group compound semiconductor layer at a temperature higher than the temperature of the crystal growth temperature of said III-V group compound semiconductor up to reaching said substrate; and
a double-hetero structure comprising a first conductivity type cladding layer, a multi-quantum well structure active layer, and a second conductivity type cladding layer which are selectively grown so as to bury said stripe shaped groove, with replacing said etching gas used in said etching by crystal growth gas without the surfaces of said plurality of stripe shaped grooves being exposed to the external air.

Therefore, it is possible to form simultaneously a plurality of double hetero structures provided with multi-quantum well structure active layers having different thicknesses on the same substrate.

According to a twenty-fifth aspect of the present invention, a semiconductor laser, comprises:
a first conductivity type III-V group compound semiconductor substrate;
a plurality of mesa-stripes which are formed by forming a first insulating film having a plurality of stripe shaped openings having different widths mutually parallel on a main surface of said first conductivity type III-V group compound semiconductor substrate,
selectively etching said III-V group compound semiconductor substrate using said first insulating film as a mask by an etching method for semiconductor, that etches a III-V group compound semiconductor using an etching gas including V group material forming said IIIV group compound semiconductor layer and keeping said III-V group compound semiconductor layer at a temperature higher than the temperature of the crystal growth temperature of said III-V group compound semiconductor, thereby to form a plurality of stripe shaped grooves,
selectively growing a double-hetero structure comprising a first conductivity type cladding layer, a multi-quantum well structure active layer, and a second conductivity type cladding layer so as to bury said plurality of stripe shaped grooves, with replacing said etching gas used in said etching by crystal growth gas without the surfaces of said plurality of stripe shaped grooves being exposed to the external air,
after removing said first insulating film, forming a stripe shaped second insulating film extending in the length direction of said double hetero structure on said double hetero structure, and etching said double-hetero structure using said second insulating film as a mask; and
a current blocking layer formed so as to bury said mesa-stripe using said second insulating film as a mask.

Therefore, it is possible to form simultaneously a plurality of double hetero structures provided with multi-quantum well structure active layers having different thicknesses on the same substrate.

### BRIEF DESCRIPTION OF THE DRAWINGS

Figures 1(a)-1(d) are diagrams illustrating configurations of the etched grooves which are formed by the thermal etching according to a first embodiment of the present invention.
Figures 2(a)-2(b) are diagrams illustrating configurations of the ridges which are formed by the thermal etching according to the first embodiment of the present invention.
Figures 3(a)-3(b) are diagrams illustrating configurations of the V shaped grooves which are formed by the thermal etching according to the first embodiment of the present invention.
Figures 4(a)-4(b) are a diagram illustrating a relation between etching depth and aperture width, which shows the relation between the aperture width of a mask and the etching rate, for the apertures of the mask and the a cross-sectional view of the apertures according to the first embodiment of the present invention.
Figures 5(a)-5(b) are a diagram illustrating a relation between etching depth and aperture width, which shows differences in the etching rates in the apertures, for the apertures of the mask and a cross-sectional view of the apertures in the thermal etching according to the first embodiment of the present invention.
Figures 6(a)-6(d) are diagrams illustrating the relation between the distance between the apertures of a mask and the etching rate in the thermal etching according to the first embodiment of the present invention.
Figures 7(a)-7(c) are cross-sectional views illustrating a fabricating method of a diffraction grating provided with a V shaped groove according to a second embodiment of the present invention.
Figure 8 is a cross-sectional view illustrating a structure of a diffraction grating provided with a V-shaped groove according to a second embodiment of the present invention.
Figures 9(a)-9(c) are cross-sectional views illustrating a fabricating method of a diffraction grating according to an alternative of a second embodiment of the present invention.
Figures 10(a)-10(b) are diagrams for explaining a fabricating method of a diffraction grating according to a third embodiment of the present invention.
Figures 11(a)-11(b) are diagrams for explaining a fabricating method of a diffraction grating according to a fourth embodiment of the present invention.
Figure 12(a)-12(b) are diagrams for explaining a fabricating method of a diffraction grating according to a third embodiment of the present invention.
Figures 13(a)-13(b) are diagrams for explaining a fabricating method of a diffraction grating according to a fourth embodiment of the present invention.
Figures 14(a)-14(f) are diagrams for explaining a fabricating method of a DFB laser according to a fifth embodiment of the present invention.
Figures 15(a)-15(d) are diagrams for explaining a fabricating method of a DFB laser according to a sixth embodiment of the present invention.
Figures 16(a)-16(b) are diagrams for explaining a fabricating method of a DFB laser according to a seventh embodiment of the present invention.
Figures 17(a)-17(d) are diagrams for explaining a fabricating method of a DFB laser according to an eighth embodiment of the present invention.
Figures 18(a)-18(b) are diagrams for explaining a fabricating method of a DFB laser according to an alternative of an eighth embodiment of the present invention.
Figures 19(a)-19(d) are diagrams for explaining a fabricating method of a DFB laser according to a ninth embodiment of the present invention.
Figures 20(a)-20(b) are diagrams for explaining a fabricating method of a DFB laser according to an alternative of a ninth embodiment of the present invention.
Figures 21(a)-21(d) are diagrams for explaining a fabricating method of a DFB laser according to a tenth embodiment of the present invention.
Figures 22(a)-22(d) are diagrams for explaining a fabricating method of a DFB laser according to an alternative of a tenth embodiment of the present invention.
Figures 23(a)-23(d) are diagrams for explaining a fabricating method of a DFB laser according to an eleventh embodiment of the present invention.
Figure 24 is a diagram for explaining a leakage current path of a semiconductor laser according to an eleventh embodiment of the present invention.
Figure 25 is a diagram illustrating a relation between the taken in efficiency of the carriers of into crystal and the crystal surface direction according to the eleventh embodiment of the present invention.
Figure 26 is a diagram illustrating a structure of a semiconductor laser according to an alternative of the present invention.
Figures 27(a)-27(d) is a cross-sectional view illustrating a fabricating method of a semiconductor laser according to a twelfth embodiment of the present invention.
Figures 28(a)-28(b) are diagrams illustrating a structure of a semiconductor laser according to an alternative of the twelfth embodiment of the present invention.
Figure 29 is a diagram illustrating a structure of a semiconductor laser according to another alternative of the twelfth embodiment of the present invention.
Figures 30(a)-30(d) are diagrams for explaining a fabricating method of a semiconductor laser according to a thirteenth embodiment of the present invention.
Figures 31(a)-31(d) are diagrams for explaining a fabricating method of an integrated semiconductor laser and light modulator according to a fourteenth eleventh embodiment of the present invention.
Figures 32(a)-32(e) are diagrams for explaining a fabricating method of an integrated semiconductor laser and light modulator according to the fourteenth embodiment of the present invention.
Figures 33(a)-33(b) are diagrams for explaining an etching method for semiconductor according to a fifteenth embodiment of the present invention.
Figures 34(a)-34(d) are diagrams for explaining a fabricating method of a semiconductor laser array according to a sixteenth embodiment of the present invention.
Figures 35(a)-35(d) are diagrams for explaining a fabricating method of a semiconductor laser array according to an alternative of a sixteenth embodiment of the present invention.
Figures 36(a)-36(d) are diagrams for explaining a fabricating method of a semiconductor laser array according to a seventeenth embodiment of the present invention.
Figures 37(a)-37(g) are diagrams for explaining a fabricating method of an integrated semiconductor laser and light modulator according to an eighteenth embodiment of the present invention.
Figures 38(a)-38(c) are diagrams for explaining an etching method for semiconductor according to a nineteenth embodiment of the present invention.
Figures 39(a)-39(d) are diagrams for explaining a fabricating method of a quantum wire structure according to a twenty embodiment of the present invention.
Figures 40(a)-40(d) are diagrams for explaining a fabricating method of a quantum wire structure according to an alternative of a twentieth embodiment of the present invention.
Figures 41(a)-41(d) are diagrams for explaining a fabricating method of a quantum wire structure according to another alternative of a twenty embodiment of the present invention.
Figures 42(a)-42(d) are diagrams for explaining an etching method for semiconductor according to the prior art.

### DETAILED DESCRIPTION OF THE PREFERRED EMBODIMENTS

### Embodiment 1.

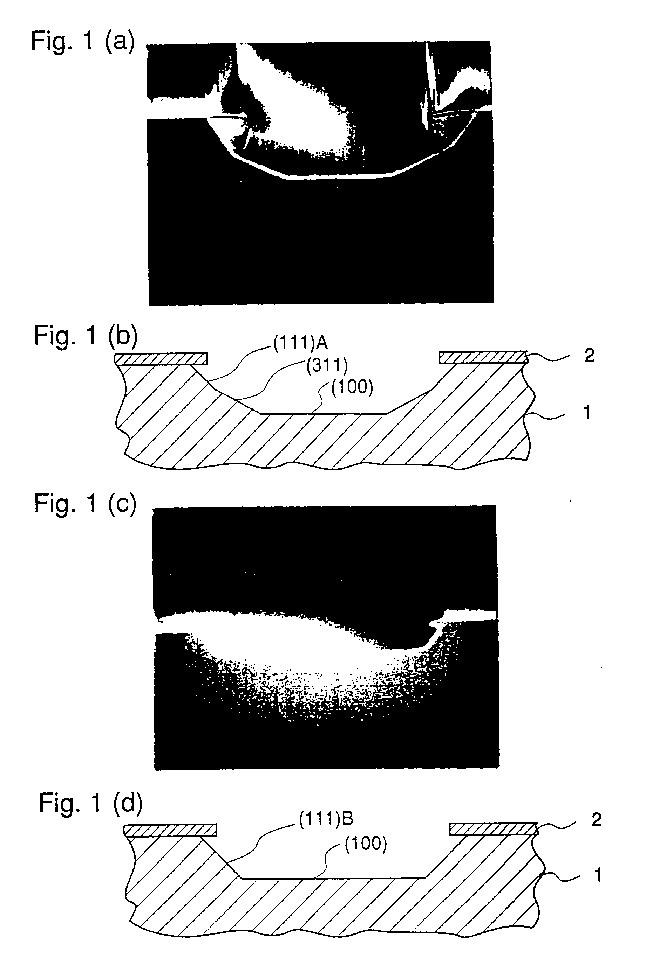

Figures 1(a)-1(d) are diagrams for explaining the semiconductor etching method according to a first embodiment of the present invention in which figures 1 (a) and 1 (b) are a cross-sectional view and a cross-sectional schematic view in a (011) plane of an InP substrate after the etching, respectively, and figures 1(c) and 1(d) are a cross-sectional view and a cross-sectional schematic diagram in a (011) plane of an InP substrate after the etching, respectively. In the figure, reference numeral 1 designates an InP substrate, reference numeral 2 designates an insulating film pattern having an aperture of 5∼6 µm width.

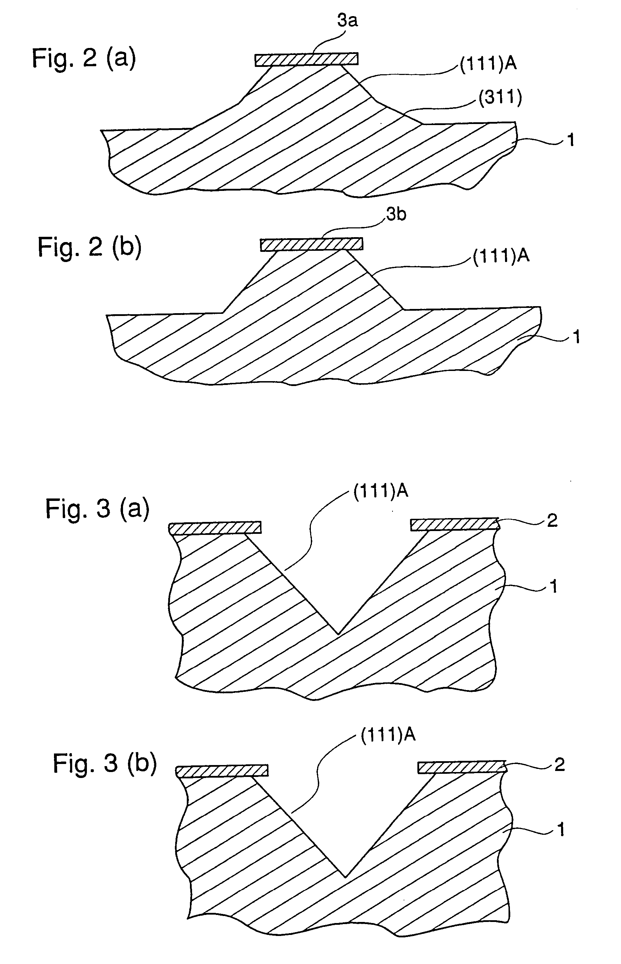

Figures 2(a)-2(b) are diagrams for explaining the semiconductor etching method according to a first embodiment of the present invention in which figures 2(a) and 2(b) are a cross-sectional view and a cross-sectional view in a (01̅1) plane and a (01̅1̅) plane, respectively, of an InP substrate. In the figures, the same reference numerals are to designates the same or corresponding elements as in figure 1. Reference numerals 3a, 3b designate stripe shaped insulating film patterns extending in the [01̅1] direction and [01̅1̅] direction.

Figures 3(a)-3(b) are a cross-sectional view in a (01̅1) plane and a cross-sectional view in a (011) plane, respectively, for explaining the semiconductor etching method according to a first embodiment of the present invention. In the figures, the same reference numerals designate the same or corresponding elements as shown in figure 1.

A description is given of the etching method according to a first embodiment of the present invention. First of all, an InP substrate 1 on a (100) just plane of which an insulating film 2 having an aperture of a prescribed width is formed is set in an MOCVD (metal organic chemical vapor deposition) apparatus, and it is held at a temperature about 50 °C above 650 °C at which growth of InP crystal is possible for one hour in the PH₃ gas atmosphere. The etching conditions then are substrate temperature Ts : 700 °C, pressure of reactor P : 30 Torr, flow rate of PH₃:400 SCCM, and hydrogen flow rate : 25 SCCM. After this etching, the cross-section configuration is observed by SEM (secondary ion microscopy), and the etching amount is evaluated by a contact system step measure and SEM.

The (01̅1) cross-section configuration of the InP substrate 1 after etching become the mesa configuration as shown in figures 1 (a) and 1 (b) and a (100) just planehaving a good surface configuration appears at the bottom of the mesa groove. In addition, the etching is performed so that the sides of the mesa become (111)A plane at its upper portion and (311) facet plane at its lower portion.

In addition, the (011) cross-section configuration of the InP substrate 1 after the etching become the mesa configuration as shown in figures 1 (c) and 1 (d) and (100) plane appears at the bottom of the mesa groove. In addition, the sides of the mesa groove are etched to a configuration having a (111)B plane facet.

Thereafter, when the InP substrate 1 is further etched using the insulating film mask 2 having the above aperture, the (01̅1) cross-section configuration and the (01̅1̅) cross-section configuration of the etched mesa groove become V shaped grooves the side surfaces of which are formed by (111)A plane as shown in figure 3(a) and 3(b). This is a phenomenon which occurs because the etching speed of the (111) plane is larger than the etching speed of the (100) plane in the etching method of the first embodiment.

Next, a stripe shaped insulating film pattern 3a extending in the [01̅1] direction is formed on the InP substrate 1, and an etching is carried out to the InP substrate 1 by the similar condition as described above using the as a mask, thereby producing the (01̅1) cross-section of the substrate 1 having a ridge configuration as shown in figure 2(a). Then, a (111)A plane is formed at an upper portion of the side of the ridge and a (311) plane is formed at a lower portion of the side of the ridge.

Similarly as above, a stripe shape insulating film pattern 3b extending in the [01̅1̅] direction is formed, and an etching is carried out to the InP substrate 1 using the insulating film pattern 3b as a mask, thereby forming a (01̅1̅) cross-section of the substrate 1 as shown in figure 2(b), the ridge side then becoming the (111)B surface.

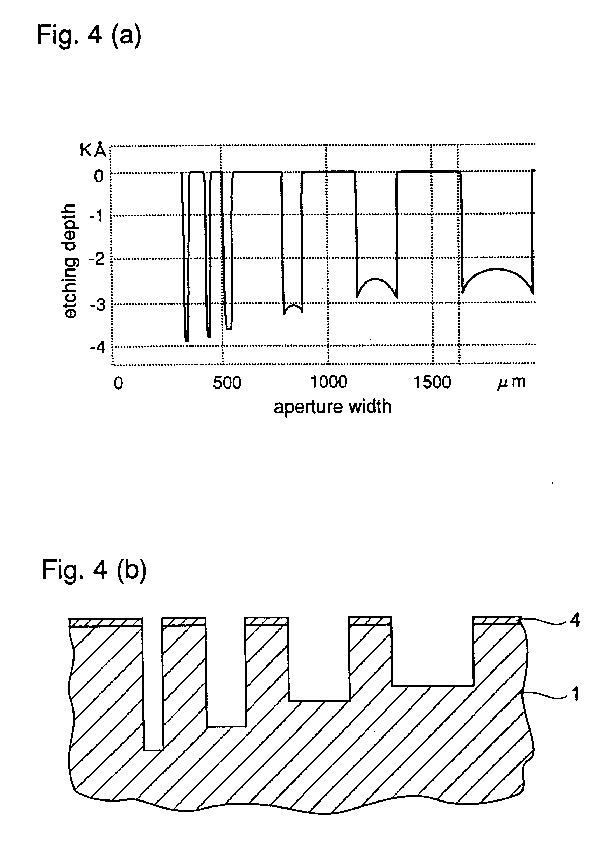

Figure 4(a) and 4(b) are a diagram illustrating the result of measurement by a contact system step measure of the etching depth when the InP substrate 1 is etched by the etching method using the insulating film 4 provided with a plurality of stripe shaped openings and a cross-sectional schematic diagram in the stripe width direction of the substrate 1 according to the first embodiment, respectively. It is found from figure 4, that according to the embodiment of the present invention, the depth of etching is deeper and the etching speed is higher as the aperture width of the opening is wider.

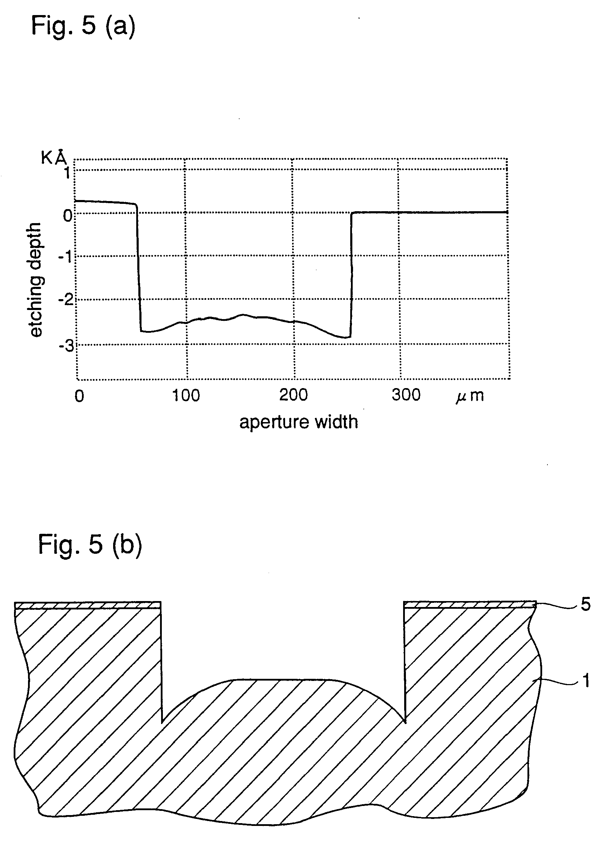

Figure 5(a) and 5(b) are a diagram illustrating the result of measurement by a contact system step measure of the etching depth when the InP substrate 1 is etched by the etching method using the insulating film 5 provided with an opening having an opening width of 200 µm as a mask, and a cross-sectional schematic diagram of the substrate 1 according to the first embodiment, respectively. It is found from figure 5, that the cross-section configuration of the etched groove is shallow as is apart from the mask, whereby the etching rate is larger as close to the vicinity of the mask. Here, the result of measurement by the contact step meter of shown in figures 4(a)-4(b) and 5(a)-5(b) are high in its precision in the depth direction of the groove and low in its precision in the width direction. In addition, the opening widths of the insulating films 4, 5 are sufficiently larger than the opening widths of the insulating film 2 shown in figure 1. Here, though the side surface configuration of the etched groove is illustrated as a configuration close to perpendicular to the surface of the substrate 1, the actual side surface of the etched groove is an inclined surface.

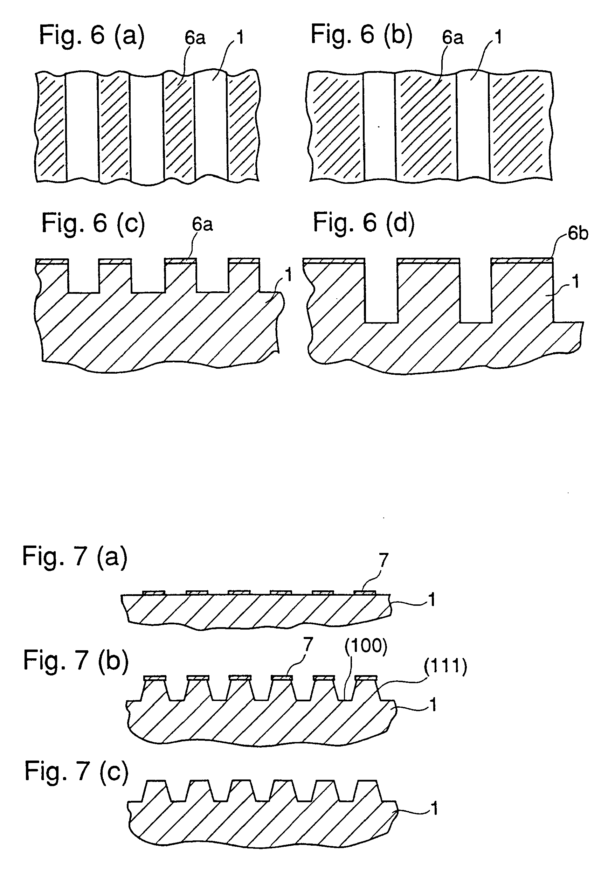

In addition, figure 6(a)-6(d) are plan views (figure 6(a), 6(b)) and cross-sectional views (figure 6(c), 6(d)) when the etching is carried out to the InP substrate 1 by an etching method of using the insulating film pattern 6a having a plurality of openings having equal opening widths and disposed with prescribed intervals and the insulating film pattern 6b having the same opening widths as the insulating film pattern 6a and having intervals which are wider than the intervals between the opening widths larger than the patterns 6a according to the first embodiment of the present invention. The cross-sections of the InP substrate 1 when the etching is carried out by using the insulating film patterns 6a, 6b as shown in figures 6(a), 6(b) become as shown in figures 6(c), 6(d), respectively, and it is presented that a high etching rate etching is possible when the etching is carried out using the insulating film pattern 6b having a wide interval between the openings.

In the first embodiment of the present invention, because etching of InP is carried out by making the temperature for keeping the InP layer in the PH₃ atmosphere a temperature about 50 °C higher than the crystal growth temperature of InP. Therefore, an etching superior in the controllability can be carried out.

While in the above-described first embodiment the etching temperature is kept by about 50 °C higher than the crystal growth temperature of InP, the etching temperature of the present invention may be a high temperature than InP.

The substrate temperature and the partial pressure of PH₃ shown in the etching method of this first embodiment are only examples. Since the etching speed varies dependent on the pressure of PH₃, flow rate of PH₃, and the like, the etching speed can be made slow up to about 1 nm/min, and such late etching rate can enhance the controllability.

### Embodiment 2.

Figure 7 is a diagram illustrating a method for fabricating a diffraction grating according to a second embodiment of the present invention using a thermal etching described in the first embodiment. In the figure, reference numeral 1 designates an InP substrate and reference numeral 7 designates a diffraction grating mask comprising an insulating film.

A description is given of a fabricating method according to this second embodiment. First of all, as shown in figure 7(a), a diffraction grating 7 provided with a plurality of stripe shaped openings arranged with 1000∼1500 angstroms pitches in the [01̅1] direction is formed on the (100) plane of the InP semiconductor substrate 1. Next, as shown in figure 7(b), the InP substrate 1 is etched by the thermal etching described in the first embodiment using the diffraction grating mask 7 as a mask. Then, the inclined plane in the lattice arranging direction of the groove position of the diffraction grating becomes (111) plane and the bottom surface thereof becomes the (100) plane. Thereafter, as shown in figure 7(c), the insulating film 7 is removed to obtain a diffraction grating.

In this embodiment, the diffraction grating is formed by the thermal etching. Therefore, the diffraction grating can be obtained with higher controllability than when wet etching is used. In addition, as described in the first embodiment the etching speed can be controlled by controlling the PH₃ partial pressure, the PH₃ flow rate, the substrate temperature, and the like, and by controlling the etching speed to be late as about 1 nm/min, it is possible to form a diffraction grating of minute height of about 10 nm with high controllability.

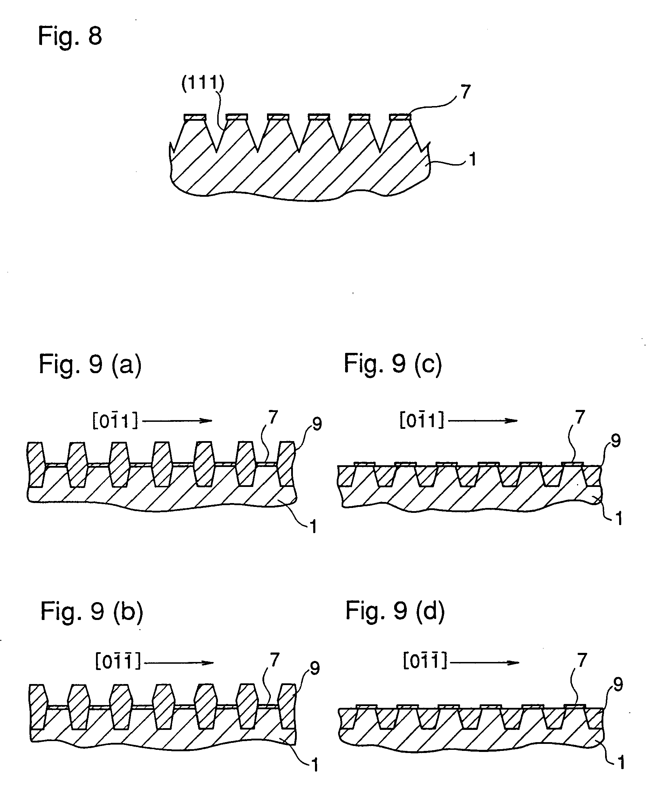

After conducting the thermal etching in the above-described second embodiment, a further thermal etching may be carried out to form a V-shaped groove comprising a (111) plane as a groove of the diffraction grating as shown in figure 8. In this case, when the V-shaped groove comprising a (111) plane if formed, the etching speed is made slow and it appears as the etching is stopped. Accordingly, when a diffraction grating having a V-shaped cross-section configuration for grooves is formed, the control of the configuration of the diffraction grating is eased.

While in the above-described embodiment the arranging direction of the stripe groove of the diffraction grating is made (01̅1) direction, the present invention can be applied to a case where the arranging direction of the stripe shaped groove of the diffraction grating is other direction such as (01̅1̅) direction. Also in these cases, the same effects as in the above-described second embodiments are obtained.

After the diffraction grating shown in the second embodiment is formed, a semiconductor layer may be formed in the diffraction grating as described below. Figure 9(a) and 9(c) are cross-sections in (01̅1̅) direction and figures 9(b) and 9(d) are cross-sections in (01̅1̅) directions for explaining a fabricating method of a diffraction grating as an alternative of a second embodiment of the present invention. In the figures, the same reference numerals designate the same or corresponding elements. Reference numeral 9 designates a regrown layer comprising a semiconductor material such as InP.

The regrowth method will be described. First of all, the InP substrate 1 on which an insulating film 7 is formed is disposed in the MOCVD apparatus and the diffraction grating is formed by etching as shown in figure 7(b) and, thereafter, the atmosphere in the apparatus is replaced by the atmosphere for crystal growth without the substrate 1 being exposed to the outside air, and the regrowth layer 9 is grown. For example, when the arranging direction of the diffraction grating is [01̅1], a projection having a cross-section of trapezoid configuration is formed on a surface of the substrate 1 as shown in figure 9(a). In addition, when the arranging direction of the diffraction grating is [01̅1̅], a projection having a cross-section of trapezoid configuration for its upper part and a cross-section of reverse trapezoid configuration is formed as shown in figure 9(b). Here, in both of the arranging direction of the diffraction grating is [01̅1] or [01̅1̅], the growth of the regrowth layer 9 may be stopped at the same height as the surface of the substrate 1 as shown in figures 9(c) and 9(d).

In such cases, the semiconductor layer such as InP can be grown without being exposed to the air after etching the InP substrate, and the diffraction grating that has suppressed the growth of impurities such as oxide films can be obtained.

In the alternative of the second embodiment, the cases in which the arranging direction of the stripe groove of the diffraction grating is [01̅1] or [01̅1̅] direction, the present invention can be applied to cases where the arranging direction of the stripe groove is other direction with the same effects as in the alternative of the second embodiment.

While in the above-described alternative of the second embodiment, InP is employed as a layer that is regrown on the diffraction grating, any layer for protecting the etched surface may be grown as a crystal that is to be regrown.

Further, while in the alternative of the second embodiment the regrowth layer such as InP is formed on the diffraction grating so as to suppress such as generation of impurities onto the regrowth interface, in the present invention, after forming a grating groove on a semiconductor layer such as a substrate by thermal etching, a layer comprising a material which is to be a diffraction grating layer may be selectively grown as shown in figures 9(a) and 9(b).

### Embodiment 3

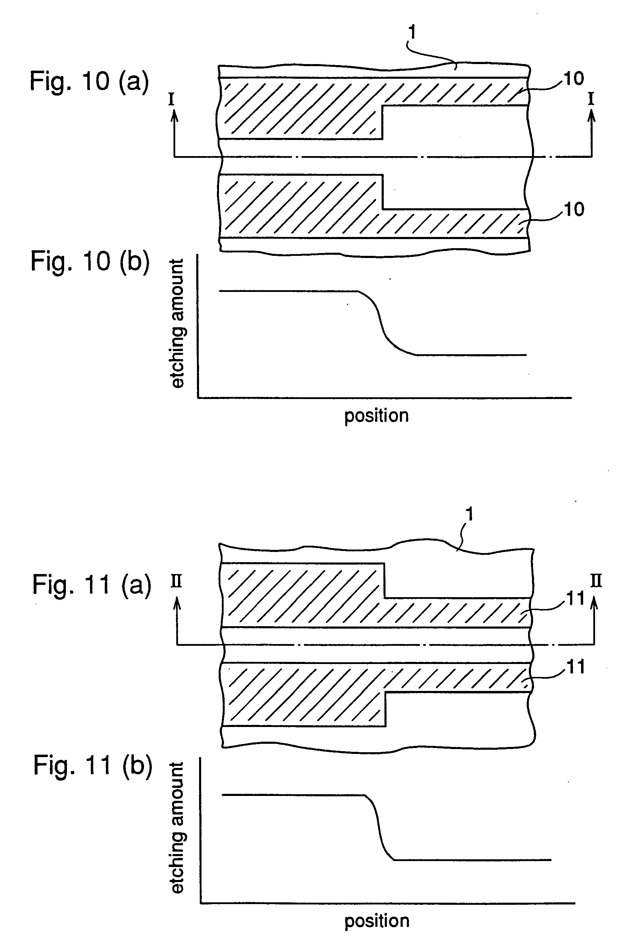

Figures 10(a)-10(b) are diagrams for explaining the fabricating method of a diffraction grating using a thermal etching described in the first embodiment, according to a third embodiment of the present invention. In the figures, the reference numerals as those in figure 1 designate the same or corresponding elements. Reference numeral 10 designates an insulating film provided with a stripe shaped aperture extending in the [01̅1̅] direction, and the aperture is formed to have a width broader than the width of the other region.

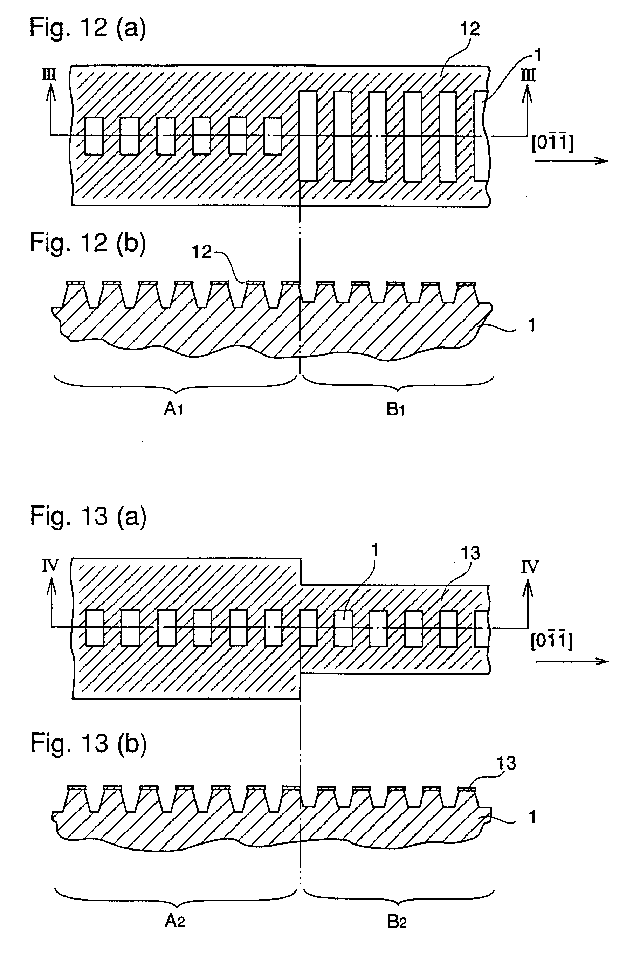

Figures 12(a)-12(b) are diagrams for explaining the fabricating method of a diffraction grating according to a third embodiment of the present invention. In the figure, reference numeral 12 designates a diffraction grating mask comprising an insulting film having a plurality of stripe shaped apertures arranged in the [01̅1̅] direction with pitches of 1000∼1500 Å. The stripe shaped apertures provided at a region B1 in the [01̅1̅] direction of the diffraction grating is formed to have a stripe length longer than the aperture provided at a region A1 at the side opposite the [01̅1̅] direction. For example, the stripe length of the aperture of the region A1 is about 50 µm and the stripe length of the aperture of the region B1 is several 100 µm.

A description is given of the fabricating method. First of all, as shown in figure 12(a), a diffraction grating 12 having stripe shaped apertures arranged on a (100) plane of the InP substrate 1 with pitches of 1000∼1500 Å in parallel with each other are formed. Next, the InP substrate 1 is etched using the same as a mask employing the thermal etching that is employed in the first embodiment.

Here, as described in the first embodiment with reference to figure 4, the thermal etching has a property that as the width of the aperture is narrower, the depth of the etching is deeper. Consequently, when the thermal etching is carried out by using an aperture pattern as shown in figure 10(a), the etching quantity in the I-I cross-section is illustrated as in figure 10(b). In other words, the etching quantity at a portion of the stripe shaped apertures having a large width is smaller than the etching quantity of the other portion and the depth of the etched groove becomes shallower than the depth of the other portion of the etched groove. Therefore, the III-III cross-section after the thermal etching of the InP substrate 1 shown in figure 12(b) becomes as shown in figure 12(b), and a diffraction grating in which the etched groove at the region B1 at the side of the [01̅1̅] direction is shallower than the etched groove at the region A1 opposite to the [01̅1̅] direction is formed.

In this third embodiment, the similar effects as in the second embodiment are obtained as well as a diffraction grating having grooves of different depths for the arranging directions of the diffraction grating can be obtained at the same time, thereby shortening the fabricating process of such diffraction grating.

### Embodiment 4.

Figures 11(a)-11(b) are diagrams for explaining a fabricating method of a diffraction grating using the thermal etching described in the first embodiment according to a fourth embodiment of the present invention. In the figures, the same reference numerals as in figure 1 designates the same or corresponding elements. Reference numeral 11 designates an insulating film provided with stripe shaped apertures, and this insulating film is formed to have the width of the aperture at one end side in the stripe length direction smaller than the width of the other region, and the aperture is formed to have a constant width.

Figures 13(a)-13(b) are diagrams for explaining a fabricating method of a diffraction grating according to a fourth embodiment of the present invention. In the figure, the same reference numerals as those shown in figure designate the same or corresponding elements. Reference numeral 13 designates a diffraction grating mask comprising an insulating film having a plurality of apertures arranged in parallel in the [01̅1̅] direction with pitches of 1000∼1500 Å. The diffraction grating mask 13 is formed such that the width of the region B2 at the side of [01̅1̅] direction is narrower than the width of the region A2 at the side opposite the [01̅1̅] direction and that the stripe length of the stripe shaped apertures are all equal to each other.

A fabricating method will be described. First of all, as shown in figure 13(a), on a (100) plane of an InP substrate 1, a diffraction grating mask 13 having stripe shaped apertures arranged in parallel with each other with prescribed pitches of 1000∼1500 Å is formed. Next, the InP substrate 1 is thermally etched using the diffraction grating mask 13 by the thermal etching employed in the first embodiment.

Here, as described in the first embodiment with reference to figure 6, the thermal etching has a property that the depth of etching against the aperture of the mask becomes deeper as the width of masks which are adjacent to each other is wider. Therefore, when the InP layer 1 is thermally etched using the aperture pattern as shown in figure 11 (a), the etching quantity in the II-II cross-section is shown as in figure 11 (b). Particularly, in the region of the stripe shaped aperture which is adjacent to a portion of the insulating film 11 having a wide width, the etching quantity becomes larger than the etching quantity through the other portion of the aperture, and the depth of the etched groove becomes shallower than the depth of the etched groove of the other portion. Accordingly, also in this fourth embodiment, the depth of the etched groove through the aperture provided at the region B having a narrow width of the insulating film 13 becomes shallower than the depth of the etched groove through the aperture of provided at the region A2 having a wide width of the insulating film 13. Accordingly, the IV-IV cross-section after the thermal etching of the InP substrate 1 which is shown in figure 13(a) becomes as shown in figure 13(b). In other words, a diffraction grating in which the etched groove at the region B2 which is positioned at the side of the [01̅1̅] direction is shallower than the etched groove at the region A2 which is positioned at the side opposite to the [01̅1̅] direction is formed.

Also in this fourth embodiment, diffraction gratings having grooves having different depths in the arranging directions of gratings can be simultaneously obtained similarly as in the third embodiment.

### Embodiment 5.

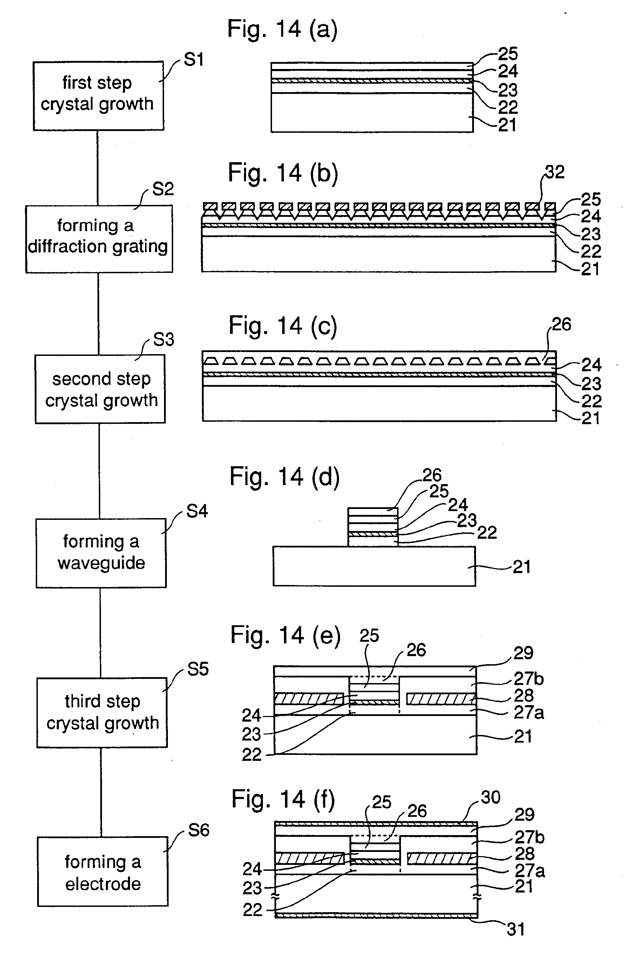

Figures 14(a)-14(f) shows a cross-sectional view a manufacture flowchart illustrating a DFB (distributed feedback) semiconductor laser using the thermal etching of the first embodiment, according to a fifth embodiment of the present invention. Figures 14(a), 14(d)-14(f) are cross-sectional views in the resonator width direction of the semiconductor laser and figure 14(b) and 14(c) are cross-sectonal views in the resonator length direction of the semiconductor laser.

In the figures, reference numeral 21 designates a p type InP substrate, reference numeral 22 designates a p type cladding layer, reference numeral 23 designates an InGaAsP active layer, reference numeral 24 designates an InP light guiding layer, reference numeral 25 designates an InGaAsP diffraction grating layer, reference numeral 26 designates an n type InP cladding layer. Numeral 32 designates an insulating film pattern, numeral 27a designates a first p type burying layer, numeral 28 designates an n type InP burying layer, numeral 29 designates an InP contact layer, numeral 30 designates an n side electrode and numeral 31 designates a p side electrode. Further, reference character S1 designates a first step crystal growth process, character S2 designates a diffraction grating formation process, character S3 designates a second step crystal growth process, character S4 designates a waveguide formation process, character S5 designates a third step formation process, and character S6 designates an electrode forming process.

A description is given of the fabricating process. First of all, as the first step crystal growth process S1 shown in figure 14(a), in the MOCVD apparatus, on a (100)just plane of the p type InP substrate 21, the p type InP cladding layer 2, the InGaAsP active layer 23, the n type InP light guiding layer 24, and the InGaAsP diffraction grating layer 25 are successively grown.

Next, in the step of figure 14(b) which is the diffraction grating forming process S2, the wafer is taken out from the MOCVD apparatus, and an insulating film (not shown) is formed on the diffraction grating layer 25, and a stripe shaped diffraction grating pattern 32 having lines arranged in parallel with each other with 1000∼1500 Å pitches in the [01̅1] direction is formed on the insulating film. Thereafter, in the MOCVD apparatus, using the insulating film pattern as a mask, from the surface of the InGaAsP diffraction grating layer 25 to the n type InP light guiding layer 24 are etched using the thermal etching described in the first embodiment, thereby forming a groove having a facet of (111) plane and obtaining a diffraction grating.

Subsequently, after the wafer is taken out from the MOCVD apparatus and the insulating film pattern 32 is removed, the second step crystal growth process S3 is performed to grow an n type InP cladding layer 26 bur-ingly the diffraction grating.

Next, a stripe shaped insulating film pattern (not shown) extending in the resonator length direction is formed on the n type InP cladding layer 26, and using this as a mask, wet etching is performed using the bromo-methanol mixture from the surface of the n type InP cladding layer 26 to reaching the InP substrate 21, thereby forming a waveguide (a mesa stripe) in the waveguide formation step S4 shown in figure 14(e), and thereafter, in the step of figure 14(e), the third step crystal growth S5 is performed, and after the first p type InP burying layer 27a, the n type InP burying layer 28, and the second p type InP burying layer 27b is formed, the contact layer 29 is grown, and in the step of figure 14(f), an n side electrode 30 is formed on the contact layer 29, and a p side electrode 31 is formed on the rear surface of the substrate 21 as the electrode formation process S6, thereby forming a long wavelength DFB laser diode.

As described above, according to this fifth embodiment, since the thermal etching described in the first embodiment is used in place of using wet etching, the etching can be controlled with high controllability and a high precision DFB laser can be obtained.

### Embodiment 6.

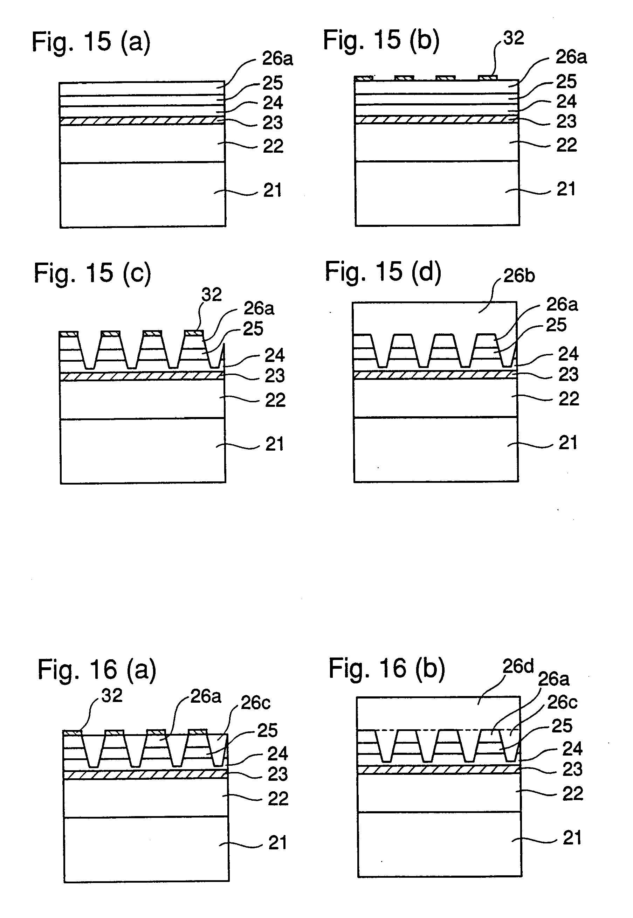

Figures 15(a)-15(d) are diagrams illustrating the main process steps of a fabricating method of a DFB laser diode according to a sixth embodiment of the present invention. In the figures 15(a)-15(d), the reference numerals designates the same or corresponding elements as those shown in figure 14. Reference numeral 26a designates a first n type InP cladding layer and numeral 26b designates a second n type InP cladding layer.

This sixth embodiment is constructed such that the first n type InP cladding layer 26a is formed on the surface of the diffraction grating layer 25 in the first step crystal growth as shown in figure 15(a), the diffraction grating pattern 32 is formed on the surface as shown in figure 15(b), the thermal etching is performed from the surface of the first InP cladding layer 26a to reaching the n type InP light guiding layer 24 using the diffraction grating pattern 32 as a mask, to form a groove having a (111) facet as shown in figure 15(c), and the second n type InP cladding layer 26b is formed as shown in figure 15(d). Also in this case, the same effects as in the fifth embodiment are obtained.

### Embodiment 7.

Figures 16(a)-16(b) are diagrams illustrating cross-sectional views of main process steps of a fabricating method of a DFB semiconductor laser according to a seventh embodiment of the present invention. In the figures, reference numerals as those shown in figures 15(a)-15(d) designate the same of corresponding elements. In the figures, reference numeral 26c designates a third n type InP cladding layer and numeral 26d designates a fourth n type InP cladding layer.

In this sixth embodiments, after forming a diffraction grating groove by thermal etching in an MOCVD apparatus in the step of figure 15(c), the wafer is taken out from the MOCVD apparatus, the diffraction grating pattern 32 is removed, and the second n type InP cladding layer 26b is again grown in the MOCVD apparatus. In this seventeenth embodiment, after a groove is formed by thermal etching as shown in figure 16(a), without taking the wafer out from the MOCVD apparatus, i.e., without the air being exposed to the external air, the ambient in the MOCVD apparatus is changed to an ambient for crystal growth and the third cladding layer 26c is again grown to the same height as that of the first n type InP cladding layer 26a, and then the wafer is taken out from the MOCVD apparatus, and the diffraction grating pattern 32 is removed, and further as shown in figure 16(d), the fourth InP cladding layer 26d is grown.

In the prior art semiconductor laser provided with the diffraction grating structure such as a DFB laser, an oxide film is formed on the regrowth interface on the diffraction grating at the regrowth, and energy levels due to the impurities are produced on the surface of the diffraction grating, the loss of light increases, and a preferable laser characteristics is not obtained. However, in this seventh embodiment, without the regrowth interface of the diffraction grating layer 25 being exposed to the external air, generation of impurities such as oxide films on the surface of the diffraction grating layer 25 can be suppressed, and a DFB laser having a clean regrowth interface can be obtained. As a result, no energy levels due to impurities are formed on the surface of the diffraction grating and a DFB laser having less loss of light is obtained.

### Embodiment 8.

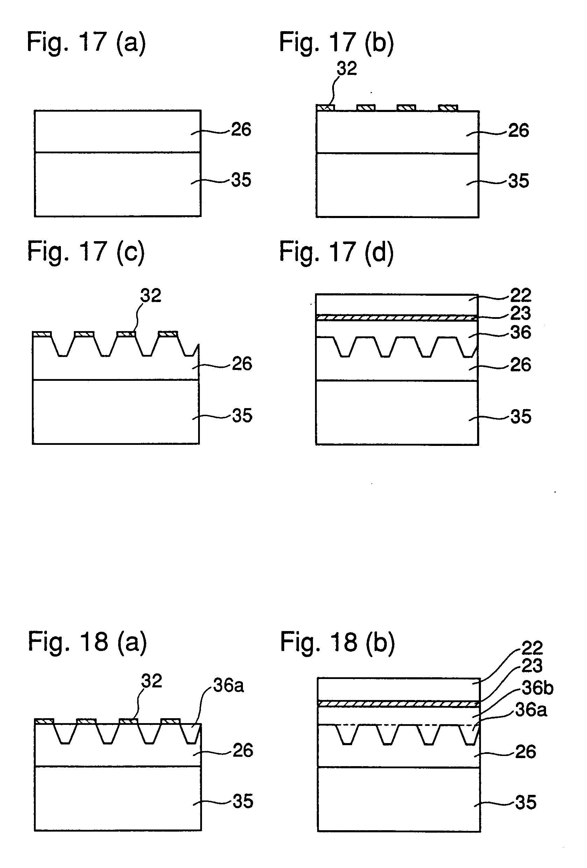

Figures 17(a)-17(d) are diagrams illustrating a fabricating method of a DFB laser according to an eighth embodiment of the present invention. In the figures, the same reference numerals designate the same or corresponding elements as those in figure 14. Reference numeral 35 designates an n type InP substrate, numeral 36 designates an n type InGaAsP light guiding layer.

In the DFB laser of this eighth embodiment, the conductivity types of respective layers are reversed to those in the fifth embodiment, the diffraction grating if formed between the active layer 23 and the n type InP substrate 35 and the material of the light guiding layer 36 is made n type InGaAsP. That is, similarly as in the fifth embodiment, as shown in figure 17(a), the n type InP cladding layer 26 is grown on the n type InP substrate 35, the diffraction grating pattern 32 is formed on the n type InP cladding layer 26 as shown in figure 17(b), the diffraction grating groove if formed by the thermal etching shown in the first embodiment as shown in figure 17(c), the insulating film 32 is removed, and the light guiding layer 36, the active layer 23, and the n type InP cladding layer 22 is formed, whereby the same effects as in the fifth embodiment are obtained.

In the above-illustrated eighth embodiment, the n type InGaAsP light guiding layer 36 is formed. However, as shown in figure 18(a), it may be that after the diffraction grating groove is formed by the thermal etching, without taking out the wafer from the MOCVD apparatus, i.e., without the wafer being exposed to the external air and with replacing the ambient in the MOCVD apparatus by the ambient for crystal growth, the first n type InP GaAs-InP light guiding layer 36b is again grown, thereafter, the wafer is taken out from the MOCVD apparatus, as shown in figure 18(b), and after removing the diffraction grating pattern 32, the second n type InGaAsP light guide layer 36b is grown. Also in this case, the same effects as in the eighth embodiment is obtained as well as a laser diode provided with superior characteristics having a clean regrowth interface of the diffraction grating structure is obtained.

### Embodiment 9.

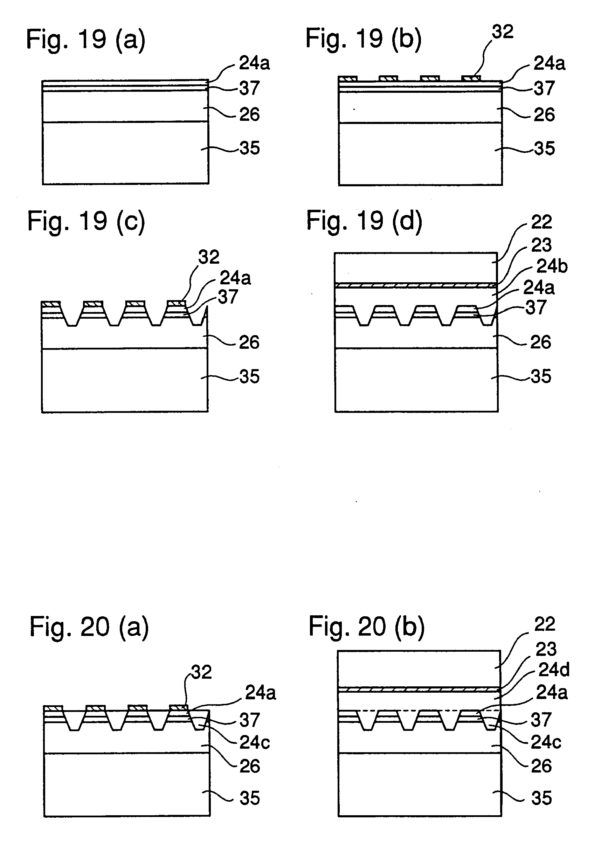

Figures 19(a)-19(d) are diagrams illustrating a fabricating method of a DFB laser according to a ninth embodiment of the present invention. In the figures, the same reference numerals designate the same or corresponding elements as those in figure 14. Reference numerals 24a, 24b designate a first and a second n type InP light guiding layer, and reference numeral 37 designates an n type InGaAsP diffraction grating layer.

This ninth embodiment employs the first and the second light guiding layers 24a, 24b in place of the n type InGaAsP light guiding layer 36. More particularly, on the n type InP substrate 35, the n type InP cladding layer 26, the n type InGaAsP layer 37, and the first InP light guiding layer 24a is formed as shown in figure 19(a), a diffraction grating pattern 32 is formed on the surface as shown in figure 19(b), and using the same as a mask, the thermal etching is performed from the first InP light guiding layer 24a up to reaching the n type InP cladding layer 26 to form a groove having a (111) plane facet (figure 19(c)). Further, after the diffraction grating pattern 32 is removed, the second n type InP light guiding layer 26b if formed so as to bury the same, with the same effects as in the above-described embodiment.

In the above-described ninth embodiment, the n type InP light guiding layer 24b is formed. However, as shown in figure 20(a), it may be that after the diffraction grating groove is formed by the thermal etching, without taking the wafer out from the MOCVD apparatus, i.e., without the wafer being exposed to the external air and with replacing the ambient in the MOCVD apparatus by the ambient for crystal growth, the third InP light guiding layer 24c is again grown, and then, the wafer is taken out from the MOCVD apparatus, the insulating film is removed, and further the fourth n type InP light guiding layer 24d is grown. Also in this case, the same effects as in the eighth embodiment is obtained as well as a laser diode provided with superior characteristics having a clean regrowth interface is obtained.

### Embodiment 10.

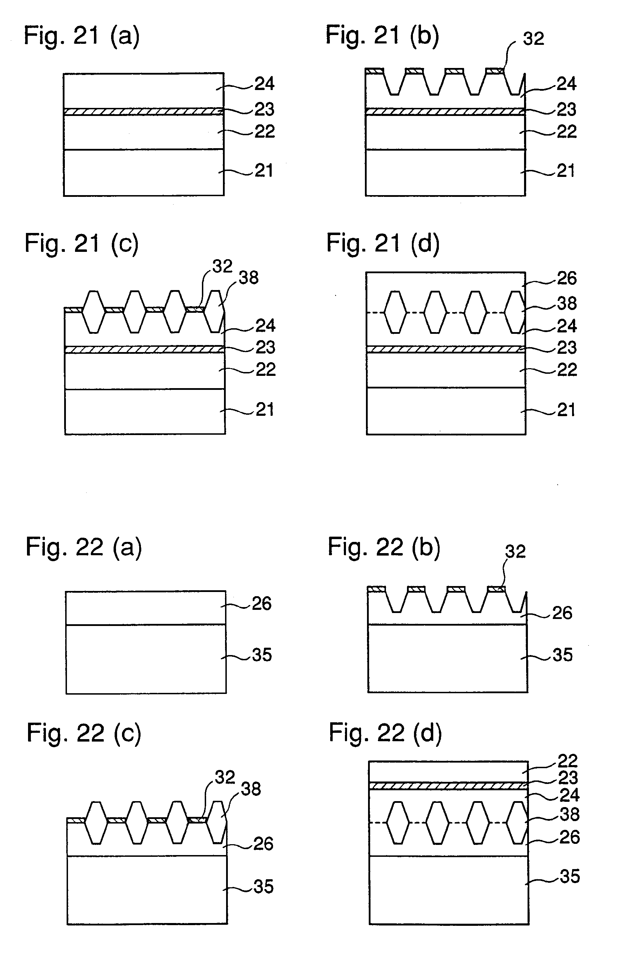

Figures 21(a)-21(d) are cross-sectional views in the resonator length direction illustrating a fabricating method of a DFB laser according to a tenth embodiment of the present invention. In the figures, the same reference numerals designate the same or corresponding elements as those in figure 14. Reference numeral 38 (the same numeral is used for different layer) designates an n type InGaAsP regrowth layer.

In the above-described fifth embodiment, as shown in figure 14(a), the n type InP cladding layer 24, the n type InGaAsP diffraction grating layer 26 is formed on the active layer 23, and the n type InGaAsP diffraction grating layer 26 is thermally etched using the diffraction grating mask 32, to form the diffraction grating as shown in figure 14(b). In this tenth embodiment, as shown in figure 21 (a), the n type InP cladding layer 24 is formed on the active layer 23, the thermal etching is performed using the diffraction grating pattern 32 in the MOCVD apparatus (figure 21(b)), thereafter, with the inside of the MOCVD apparatus is replaced by the ambient for crystal growth without the wafer being exposed to the external air, a stripe shaped n type InGaAsP regrowth layer 38 extending in the resonator width direction having a trapezoidal cross-section in the resonator length direction is again grown in the groove formed by the thermal etching of the n type InP cladding layer 24 (figure 21(c)), the diffraction grating pattern 32 is removed, and after forming the n type InP cladding layer 26, a semiconductor laser is formed by the similar process as in the fifth embodiment, and the same effects as in the fifth embodiment are obtained as in this tenth embodiment.

In this tenth embodiment, a description is given of a case in which the fabricating method of a semiconductor laser shown in the fifth embodiment. However, the present invention can be applied to a fabricating method of a semiconductor laser provided with another diffraction grating. For example, when the fabricating method of the eighth embodiment is used, as shown in figure 22, the n type InP cladding layer 26 is formed on the n type InP substrate 35 (figure 22(a)), the n type InP substrate 35 is thermally etched using the diffraction grating pattern 32 in the MOCVD apparatus (figure 22(b)), thereafter, with the ambient inside MOCVD apparatus replaced by the ambient for crystal growth with the wafer being exposed to the external air, a stripe shaped n type InGaAsP layer 38 extending in the resonator width direction having a trapezoidal cross-section in the resonator length direction is regrown in the groove formed by the thermal etching of the n type InP cladding layer 26, thereby forming a diffraction grating (figure 22(c)), the n type InP light guiding layer 24, the InGaAsP active layer 23, and the p type InP cladding layer 22 are formed, and thereafter, the similar process as in the eight embodiment is carried out, thereby forming a semiconductor laser. Also in this case, the same effects as in the tenth embodiment are obtained.

In the fifth to tenth embodiments, the arranging direction of the lattice groove of the diffraction grating was [01̅1̅] direction. In the present invention, the arranging direction of the lattice groove of the diffraction grating can be other directions such as 〈0/1/〉 direction, and the same effects as in the respective above-described embodiments are obtained.

While in the fifth to tenth embodiments, a description is given of a fabricating method of a DFB laser, the present invention can be applied to a semiconductor device other than a semiconductor laser device having a diffraction grating structure with the same effects as in the fifth to the tenth embodiments are obtained.

### Embodiment 11.

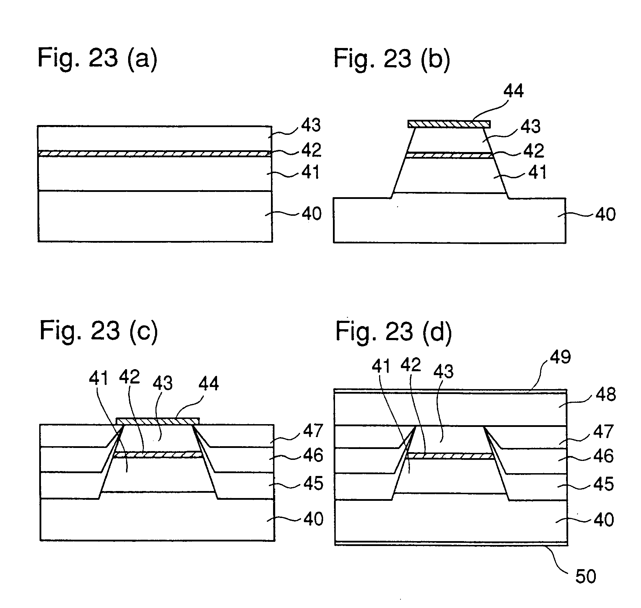

Figures 23(a)-23(d) are cross-sectional views illustrating a fabricating method of a DFB laser, using the thermal etching described in the first embodiment, according to an eleventh embodiment of the present invention. In the figures, reference numeral 40 designates a p type InP substrate, numeral 41 designates a p type InP cladding layer, numeral 42 designates an InGaAsP active layer, numeral 43 designates an n type InP cladding layer, numeral 44 designates an insulating film pattern comprising such as SiN, numeral 45, 47 designate a first and a second p type InP current blocking layer, respectively, numeral 46 designates an n type InP current blocking layer, numeral 48 designates an n type InP contact layer, numeral 49 designates an n side electrode and numeral 50 designates a p side electrode.

A description is given of a fabricating method.

First of all, as shown in figure 23(a), on a (100) just plane of the p type InP substrate 40, a doublehetero structure comprising the p type InP cladding layer 41, the InGaAsP active layer 42, and the n type InP cladding layer 43 is crystalline grown.

Subsequently, as shown in figure 23(b), an insulating film is formed on the doublehetero structure, and a stripe shaped insulating film pattern 44 having a width of several µm extending in the [01̅1̅] direction is formed by photolithography. An etching is performed using the above-described thermal etching described in the first embodiment up to reaching the InP substrate 40, thereby forming a ridge configuration having a (111) surface for its side surface.

In addition, as shown in figure 23(c), with the ambient in the MOCVD apparatus being replaced by the ambient for crystal growth with the wafer being not exposed to the external air, and using the insulating film 44 as a mask, the p type InP current blocking layer 45, the n type current blocking layer 46, and the p type InP current blocking layer 47 are selectively formed so as to bury the ridge.

Thereafter, the wafer is taken out from the MOCVD apparatus, the insulating mask 44 of the wafer is removed, and the wafer is returned to the MOCVD apparatus, and as shown in figure 23(d), the n type InP contact layer 48 is grown on the entire surface, and an n side electrode 49 and a p side electrode 50 are formed on the surface of the n type InP contact layer 48 and the rear surface of the substrate 40, respectively, and thereafter the wafer is separated into semiconductor laser diode elements.

In this eleventh embodiment, by using the thermal etching shown in the first embodiment, the ridge can be formed with high controllability, and the semiconductor laser can be formed with high reproducibility. Further, since no etching solution is used, it is possible to after forming a ridge stripe by performing the thermal etching in the MOCVD apparatus, form a regrown layer so as to bury the ridge stripe without exposing the wafer to the external air, whereby the storage of impurities such as oxides onto the regrown interface, whereby a semiconductor laser having superior characteristics are obtained.

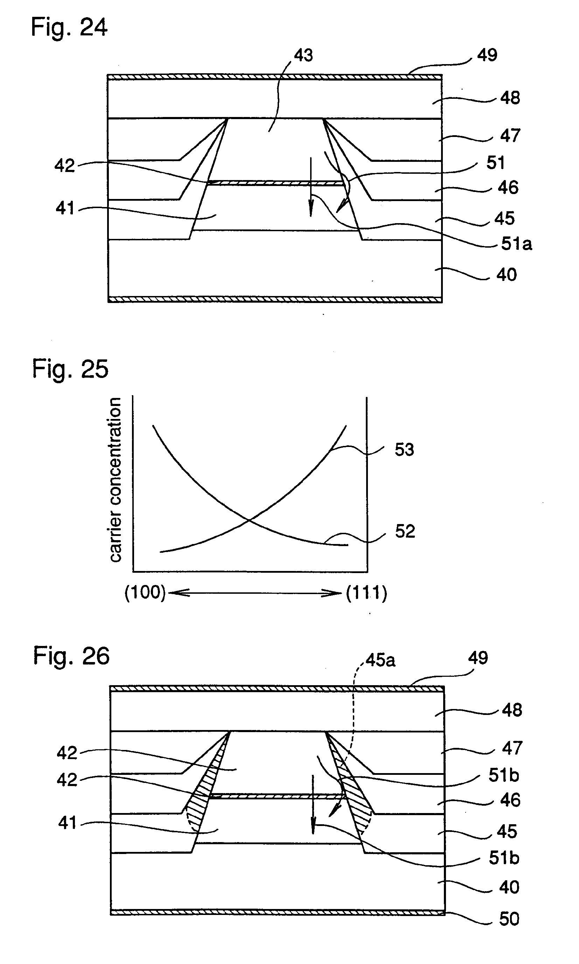

While in the semiconductor laser of the eleventh embodiment, the idle current flowing through the region other than the ridge portion is blocked by the three blocking layers comprising the first p type InP blocking layer 45, the n type first InP blocking layer 46, and the p type second InP blocking layer 47, so as to make a current 51a flow through the ridge structure portion, there may be a case in which a leak current 51 flows through the n type InP cladding layer 43 and the first p type blocking layer 41a a to the p type InP cladding layer 41a a without flowing through the active layer 42. In figure 24, the same reference numerals as in figures 23(a)-23(d) designate the same elements. Because the leakage current largely affects on the characteristics of the laser diode, it is required to reduce the leakage current 51 by increasing the resistance of the p type InP blocking layer 45 in the vicinity of the active layer 42.

Figure 25 shows a relation between the taken in efficiency of carriers into the crystal and the crystal surface orientation when the flow rate of impurities is constant. As shown in this figure 24, the p type impurities 52 and the n type impurities 53 has crystal surface dependency of the taken in efficiency into the crystal in which the p type impurities 52 has a decreasing taken in efficiency from the (100) surface to (111) surface, and the n type impurities 53 has an increasing taken in efficiency from the (100) surface to (111) surface. Therefore, when p type impurities as well as n type impurities are supplied onto the wafer having a (100) plane and (111) inclined plane to grow InP, the inclined plane can take in a lot of n type impurities with relative to the plane.

Accordingly, when p type impurities as well as n type impurities are supplied at the growth of the p type InP blocking layer 45, a lot of impurities are taken in into the p type InP blocking layer 45 that is formed at a sloped portion of the ridge as shown in figure 26, the concentration of n type impurities compensating the p type becomes of high concentration, whereby a high resistance region 45a is obtained. In the figure 25, the same reference numerals designate the same or corresponding elements. As such impurities, for example, DEZn or H₂S may be supplied at the same time. As a result, what has been the leakage current 51 as shown in figure 24 can be made the current 51b b contributing to the light emission by blocking the same by the high resistivity region 45a. Thereby, a semiconductor laser having high efficiency with suppressing the generation of leakage current 51 can be obtained. Heretofore, it is necessary to make the quantity of the n type impurities which are supplied with the p type impurities such that the sloped surface should not become n type.

In addition, while in the eleventh embodiment the blocking layer of the p type InP blocking layer 45, the n type InP blocking layer 46, and the p type InP blocking layer 47 are provided, a current blocking layer such as an Fe-InP high resistivity layer or an AllnAs high resistivity layer lattice matching the InP substrate 40, or layers not lattice matching the InP substrate 40 such as an AIGaInP layer or an AlGaAs layer which can be used in ordinary laser diodes can be used as current blocking layer with the same effects as in the eleventh embodiment.

While in this eleventh embodiment the ridge stripe direction is made the [01̅1̅] direction, the present invention can be applied to cases where the ridge stripe direction is made the other direction such that [01̅1̅] direction, and the same effects as in the eleventh embodiment are obtained.

### Embodiment 12.

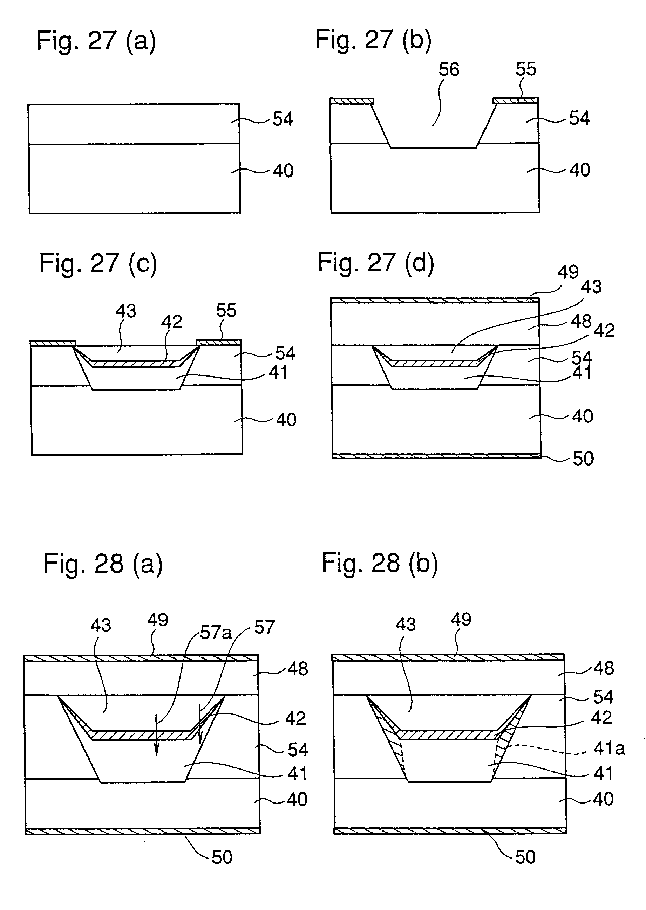

Figures 27(a)-27(d) are cross-sectional views illustrating a fabricating method of a DFB laser, using the thermal etching described in the first embodiment. This twelfth embodiment utilizes the thermal etching described in the first embodiment in a fabricating method of a semiconductor laser.

In the figures, the same reference numerals designate the same or corresponding elements. Reference numeral 54 designates an Fe doped InP (hereinafter referred to as Fe-InP) blocking layer, reference numeral 55 designates an insulating film, and reference numeral 56 designates a mesa groove.

A description is given of the fabricating method. First of all, as shown in figure 27(a), on a (100) just plane of a p type InP substrate 40, the Fe-doped InP blocking layer 54 is crystalline grown. Then, the p type InP buffer layer may be formed between the p type InP substrate 40 and the Fe-doped InP blocking layer 54. Next, an insulating film 55 is formed on the blocking layer 54, and a stripe shaped aperture having a width of several µm extending in the [01̅1̅] direction is formed by photolithography.

Subsequently, as shown in figure 27(b), the Fedoped InP layer 54 is etched up to reaching the p type InP substrate 40 by the thermal etching using the insulating film 55 as a mask in the MOCVD apparatus, thereby forming a groove 56 having a (111) B plane facet.

Thereafter, with the wafer not being exposed to the external air, a doublehetero structure comprising the p type InP cladding layer 41, the active layer 42, and the n type InP cladding layer 43 is selectively regrown so as to bury the groove 56 (figure 27(c)).

Further, after taking out the wafer form the MOCVD apparatus and removing the insulating mask 55, as shown in figure 27(d), the n type InP contact layer 48 is grown on the entire surface in the MOCVD apparatus, the n side electrode 49 and the p side electrode 50 are respectively formed on the surface of the contact layer 48 and the rear surface of the substrate 40, and then the wafer is separated into laser diode elements.

In the semiconductor laser of this twelfth embodiment, a doublehetero structure is formed in the mesa groove 56. However, since generally semiconductor material has less growth speed on the (111)B surface than on (100) surface, the active layer 42 is hardly grown on the sloped surface in the mesa groove 56. Therefore, no laser light is emitted in the active layer 42 on the sloped surface, and the laser oscillation occurs only in the active layer 42 which is on the plane parallel with the (100) plane.

In this embodiment, by using the thermal etching shown in the first embodiment, the mesa groove can be formed with high controllability and the semiconductor laser can be formed with high reproducibility. In addition, since such no etching solution is employed and after forming a mesa groove by the thermal etching in the MOCVD apparatus a doublehetero structure can be selectively grown on the mesa groove without the wafer exposed to the external air, the storage of impurities such as oxide films onto the regrowth interface can be prevented, whereby a semiconductor laser device having a superior characteristics is obtained.

While in this twelfth embodiment as shown in figure 28(a), since the doublehetero structure layer is formed also on the sloped surface of (111)B plane as shown in figure 28(a), there is a possibility that a leakage current 57 is generated which flows through the doublehetero structure layer formed at the sloped surface of the (111)B plane of the mesa groove 56, which current does not flow through the light emitting region, other than the current 57a contributing to the light emission which flows through the active layer 42 formed on the (100) plane as the light emitting region. In order to block such leakage current 57, as described in the still description in the eleventh embodiment, the p type and n type impurities may be simultaneously supplied, to grow a p type InP cladding layer 41, to make the region 41a a formed on the (111)B plane of the mesa groove 56 of the cladding layer 41, i.e., in the vicinity of the light emitting region of the active layer 42 of high resistivity. In figures 28(a)-28(b), the same reference numerals as those in figures 27(a)-27(d) designate the same or corresponding elements.

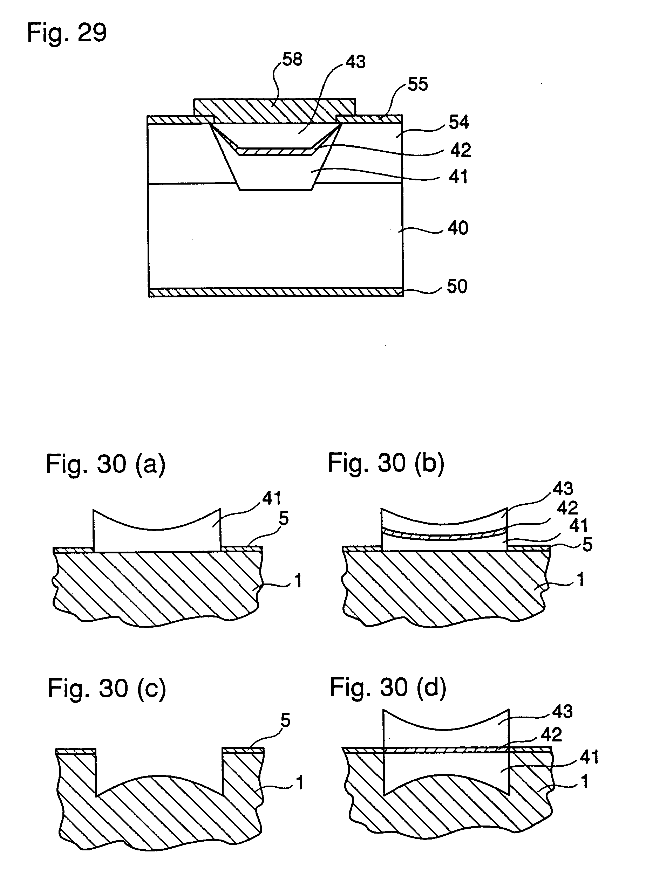

In the twelfth embodiment, a double hetero structure is formed so as to bury the groove 56, the insulating film 55 is removed and the contact layer 48 is provided, and further the n side electrode 49 is formed. In the present invention, however, it may be that after a doublehetero structure is formed so as to bury the groove 56, an Au series electrode 58 is formed on the n type InP cladding layer 43 in the aperture of the insulating film 55 with the same effects in the twelfth embodiment. Herein, in figure 29, the same reference numerals as in figure 27 designate the same or corresponding elements. Numeral 58 designates an n side electrode.

In the above-described embodiment, as a material for the current blocking layer, the Fe-InP layer is employed. In the present invention, a high resistivity layer other than that may be employed. In addition, as a structure of a blocking layer, a laminating structure comprising p type blocking layer/n type InP layer/p type InP blocking layer may be used with the same effects as in the twelfth embodiment.

### Embodiment 13.

Figures 30(a)-30(d) are diagrams illustrating a fabricating method of a DFB laser according to a thirteenth embodiment of the present invention. In the figures, the same reference numerals as in figure 5 and 27 designate the same or corresponding elements.

As shown in figure 30(a), using the insulating film mask 5 having an aperture of a predetermined aperture width formed on the InP substrate 1 as a mask, a selective growth of InP cladding layer 41 is carried out on the InP substrate 1, resulting in a growth speed higher in the vicinity of the mask due to the concentration gradient of the material in the vapor phase. Accordingly, when a selective growth of a doublehetero structure comprising the p type InP cladding layer 41, the active layer 42, and the n type InP cladding layer 43 of the laser diode is carried out using the selective mask 5, a state of figure 30(c) is obtained in which the active layer 42 is curved toward upward in the vicinity of the mask. For example, when a semiconductor laser is formed using such doublehetero structure so that the aperture width direction of the mask be the resonator length direction, a semiconductor laser having a structure in which the active layer is curved in the vicinity of the resonator facet, thereby deteriorating the laser characteristics.

On the other hand, when the selective etching is carried out to the InP substrate 1 using the thermal etching described in the first embodiment, the etching speed in the vicinity of the mask becomes high as shown in figure 5(a). Accordingly, in this thirteenth embodiment, using the thermal etching described in the first embodiment, the (100) plane of the InP substrate 1 is etched using the mask 5 (figure 30(c)), and the p type InP cladding layer 41 is formed in this etched groove. Then, the growth speed of the p type InP cladding layer 41 is higher as closer to the mask 5, the groove formed by the thermal etching is deeper as closer to the mask 5, whereby the surface of the p type InP cladding layer 41 is made flat approximately at the surface of the InP substrate 1. In addition, when the surface of the p type InP cladding layer 41 is made approximately flat, the active layer 42 is formed, and further the n type InP cladding layer 43 is grown.

According to this fabricating method of a semiconductor laser, a mesa groove is formed by using the thermal etching, and then a double hetero structure is selectively grown in the mesa groove, whereby the active layer can be made parallel with respect to the substrate surface.

### Embodiment 14.

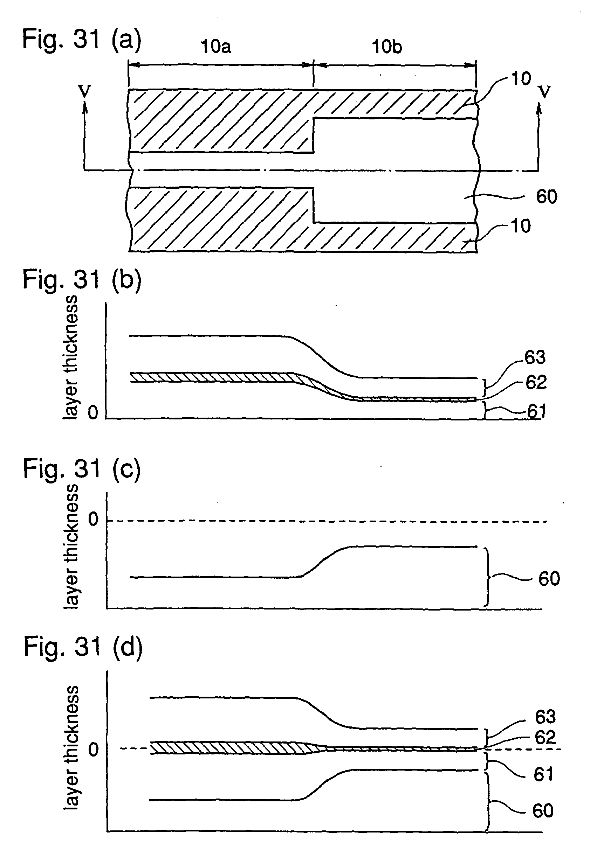

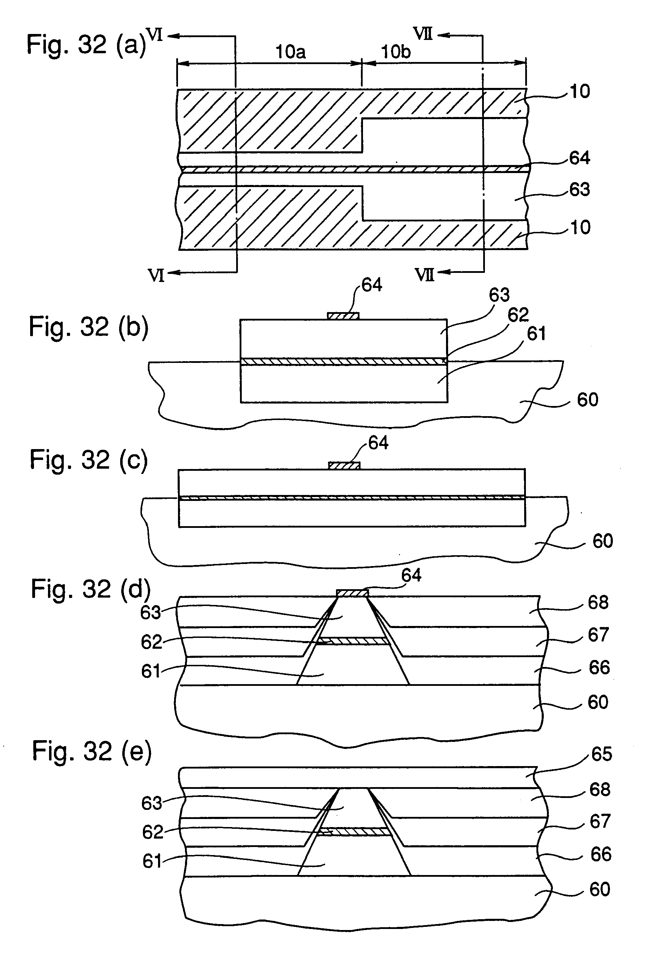

Figures 31(a)-31(d) are diagrams illustrating a fabricating method of a semiconductor laser provided with light modulator according to a fourteenth embodiment of the present invention. In the figures, the same reference numerals as in figure 32 designate the same or corresponding elements. Reference numeral 60 designates a p type InP substrate. Numeral 61 designates a p type InP cladding layer. Numeral 62 designates an active layer of a quantum well structure laminating well layers and barrier layers alternately which comprise lnₓGa₁ₓAs_{y}P₁-_{y·} Numeral 63 designates an n type InP cladding layer. Here, figure 31 (a) is a plan view illustrating an insulating film pattern 10 view from the surface side of the InP substrate 60, figures 31(b)∼31(d) cross-sectional views in line V-V of figure 30(a), respectively. In the figures 31(b)∼31(d), the abscissa represents the position on the substrate 60, and the ordinate represents the layer thickness with the height of the surface of the substrate 60 zero.

Figures 32(a)-32(e) are a plan view (figure 32(a)) viewed from the surface side of the substrate 60 illustrating a fabricating method of a semiconductor laser provided with light modulator according to a fourteenth embodiment of the present invention, cross-sections of figure 32(a) in line VI-VI (figures 32(b), 32(d), and 32(e)), and a cross-section in line VII-VII (figure 32(c)), respectively. In the figures, the same reference numerals designate the same or corresponding elements as those of figures 31. Reference numeral 64 designates a stripe shaped insulating film, numeral 65 designates an n type InP contact layer, numerals 66, 68 designate a first and a second n type InP current blocking layers, respectively, and numeral 67 designates a p type InP current blocking layer.

A description is given of the fabricating method of a semiconductor laser provided with light modulator with reference to figures 31(a)-31(d). The prior art semiconductor laser with light modulator is one integrating an LD portion and a light modulator portion monolithically utilizing the difference in the selective growth speed due to a difference in the width of the aperture of the insulating film pattern. First of all, on the p type InP substrate 60, an insulating film pattern 10 having a stripe shaped aperture extending in the length direction of the substrate 60 as shown in figure 31 (a) is formed on the p type InP substrate 60. This pattern is divided into a semiconductor laser region 10a and the light modulator region 10b in the length direction of the substrate 60, and the apertures thereof are set such that in the light modulator region 10b is larger than that in the semiconductor laser region 10a. For example, the width of the aperture in the semiconductor laser region 10a is set to about 50 µm and the width of the aperture in the light modulator region 10b is set to about 100 µm, respectively.

Subsequently, using this insulating film pattern 10 as a mask, the p type InP cladding layer 61, the quantum well structure active layer 62 comprising InGaAsP, and the n type InP cladding layer 6 are successively crystalline grown. Then, at a portion having a wide aperture width of the insulating film pattern 10, there is a nature that the crystal growth speed is slower than that at a portion having a narrow aperture width, the crystal growth speed of the light modulator region 10b becomes slower than that of the semiconductor laser region 10a, and the thickness of the respective layers of the light modulator region are thinner than those of the respective layers in the semiconductor laser region as shown in figure 31 (b). Furthermore, a contact layer (not shown) is formed on the n type InP cladding layer 63, an electrode is formed on the rear surface of the semiconductor substrate 60, and independent electrodes are formed on the contact layer in the respective semiconductor laser region 10a and the light modulator region 10b by such as evaporation, respectively, whereby a semiconductor laser with light modulator (not shown) is obtained.

A description is given of the operation of the prior art semiconductor laser with light modulator. In the prior art semiconductor laser with light modulator, the thickness of the quantum well active layer 62 in the semiconductor laser region 10a is thicker than that of the active layer 62 of the light modulator region 10b, whereby the energy band gap of the active layer 62 in the light modulator region 10b is larger than the energy band gap of the active layer 62 in the semiconductor layer region 10a. Accordingly, the laser light generated in the active layer 62 of the semiconductor laser region 10a propagates in the light modulator region 10b, and by applying a voltage or not applying a voltage to the electrode of the light modulator region 10b, the energy band gap of the active layer 62 in the light modulator region 10b becomes larger or smaller than the energy band gap of the active layer 62 in the semiconductor laser region 10a, whereby the light generated at the active layer 10a of the semiconductor laser region 10a is consecutively cut off in being output in the light modulator region 10b, thereby generating a light signal.

In the prior art semiconductor laser with light modulator, with varying the crystal growth speed using the insulating film pattern 10, the p type InP cladding layer 61, the InGaAsP quantum well active layer 62, and the n type InP cladding layer 63 are successively formed on the substrate 60 thereby to vary the thickness of the quantum well active layer 62. Therefore, there arises a positional deviation in the height direction of the active layer 62 between the semiconductor laser region 10a and the light modulator region 10b, thereby blocking the propagation of the laser light by this positional deviation, whereby the propagation characteristics of the laser light between the active layer 62 in the semiconductor laser region 10a and the active layer 62 in the light modulator region 10b cannot be sufficiently enhanced.

A description is given of a fabricating method of a semiconductor laser according to a fourteenth embodiment of the present invention, which can solve the above-described problems. First of all, as shown in figure 31 (a), an insulating film pattern 10 having a stripe shaped aperture extending in the length direction of the substrate 60 is formed on the substrate 60. This insulating film pattern 10 is separated into the semiconductor laser region 10a and the light modulator region 10b, and the aperture is adjusted so that in the light modulator region 10b is larger than that in the semiconductor laser region 10a, For example, the width of the aperture in the semiconductor laser region 10a is set to about 50µm, and the width of the aperture in the light modulator region 10b is set to about several hundreds µm.

Next, using the insulating film pattern 10 as a mask, the InP substrate 60 is thermally etched by the thermal etching described in the first embodiment. When the etching is performed in this way, the substrate 60 is etched such that the etched depth is shallow in the light modulator region 10b having a wide aperture width of the insulating film 10 and the etched depth is deep in the semiconductor laser region 10a having a narrow aperture width of the insulating film 10 (figure 31 (c)).

Thereafter, on the etched substrate 60, using the insulating film pattern 10 as a selective mask, the p type InP cladding layer 61 is formed so as to approximately bury the region removed by the etching, and then the InGaAsP quantum well active layer 62 and the n type InP cladding layer 63 are selective regrown. Then, as described above, in the selective growth, the crystal growth speed is slower at a portion of the insulating film pattern having a large aperture width, and the thickness of respective layers formed on the light modulator region 10b is thinner relative to the thicknesses of respective layers formed at the semiconductor laser region 10a. However, the etched depth in the light modulator region 10b is shallower than the etched depth of the semiconductor layer region 10a as shown in figure 31 (c). Therefore, when the quantum well active layer 62 is grown after buryingly forming the p type InP cladding layer 61 to a height closer to the surface of the substrate 60 as shown in figure 31 (d), the active layer 62 of the semiconductor laser region 10a and the active layer 62 of the light modulator region 10b can be formed at heights approximately equal to each other.

Furthermore, as shown in figure 32(a), on the n type InP cladding layer 63 formed on the aperture of the insulating film 10, a stripe shaped insulating film mask 64 having a width of about several µm existing in the length direction of the substrate 1 by photolithography. Figure 32(b) and figure 32(c) show a VI-VI cross section and a VII-VII cross section at that timing, respectively. Then, using this insulating film mask 64 as a mask, the thermal etching described in the first embodiment is performed up to reaching the substrate 60, thereby forming a mesa stripe, and thereafter, the ambient in the MOCVD apparatus is replaced by the ambient for selective growth, and the first n type InP current blocking layer 66, the p type InP current blocking layer 67, and the second n type InP current blocking layer 68 are formed so as to bury the mesa stripe. The VI-VI cross-section of the semiconductor laser region 10a then is shown in figure 32(d).

Next, the wafer is taken out from the MOCVD apparatus, the insulating film 64 is removed, and as shown in figure 32(e), the InP contact layer 65 is formed. Further, a p side electrode (not shown) is formed on the rear surface of the semiconductor substrate 60, and electrodes (not shown) are respectively formed on the surfaces of the contact layer 65 on the semiconductor laser region 10a and the light modulator region 10, respectively, thereby forming a semiconductor laser with a light modulator.

In the fabricating method of the semiconductor device according to a fourteenth embodiment of the present invention, since after performing the thermal etching of the substrate 60 using the insulating film 10 provided with an aperture having different stripe widths, a doublehetero structure is selectively grown using the insulating film mask 10 to form a semiconductor laser with light modulator, the thickness of the active layer 62 that is formed in the light modulator region 10a can be made thicker than the thickness of the active layer 62 in the light modulator region 10b as well as the heights of the active layers of the semiconductor laser region 10a and that of the light modulator region 10b can be made equal to each other, whereby a semiconductor laser with light modulator superior in the propagation property of laser light between the quantum well active layer 62 in the semiconductor laser region 10a and the quantum well active layer 62 in the light modulator region 10b is obtained.

In the above-described fourth embodiment the formation of the mesa may be performed by the wet etching used in the usual fabricating method of a semiconductor laser.

In addition, the blocking layer may be of any structure or of any material that can be used in the usual semiconductor laser.

In the eleventh to fourteenth embodiments, a description is given of a semiconductor laser. However, the present invention may be applied to any semiconductor devices other than a semiconductor laser and the same effects as in the respective embodiments are obtained.

### Embodiment 15.

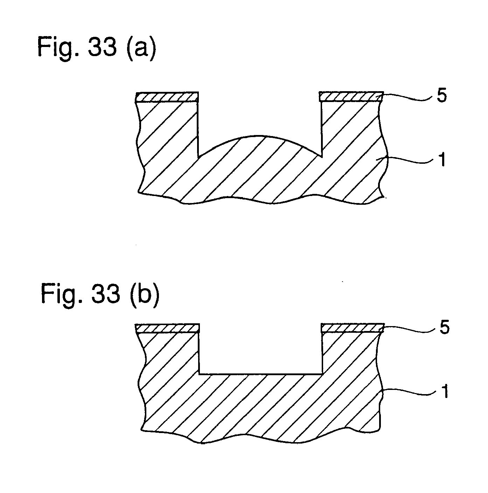

Figures 33(a)-33(b) are diagrams illustrating a semiconductor etching method according to a fifteenth embodiment of the present invention. In the figures, the same reference numerals used in figure 5 designate the same or corresponding elements. The etching method of this embodiment supplies In by adding organic metal such as TMI (trimethylindium) in the thermal etching described in the first embodiment.

In the thermal etching described in the first embodiment, the etching rate in the vicinity of the mask 5 becomes faster, and when the configuration in the depth direction of the InP substrate 1 after the etching is investigated, the cross-sectional configuration thereof becomes deep in the vicinity of the mask 5 and shallow in a portion apart from the mask. However, by supplying In by adding organic metal such as TMI in the thermal etching of the first embodiment, the etching speed in the vicinity of the mask 5 is made slower and the etched bottom can be made flat as shown in figure 33(b). This is due to that In atoms formed by the TMI being dissolved are diffused into the vapor phase and supplied to the vicinity of the mask. Further, by adding In, the etched surface can be made cleaner. In figures 33(a)-33(b), though the cross-section of the side surface of the etched groove is schematically illustrated to be perpendicular to the surface of the substrate 1, the side surface of the etched groove is actually a sloped surface.

According to this embodiment, by adding In and adjusting In addition amount in the thermal etching shown in the first embodiment, the etching speed difterence in the width direction of the aperture of a mask is controlled, thereby resulting an etching having a flat etched bottom surface. In addition, by adding In, the etching surface can be made clean.

In the fifteenth embodiment, the present invention is applied to the thermal etching described in the first embodiment. The present invention can be applied to the usual vapor phase etching using halogen series gas. For example, In can be added in the vapor etching using HCI gas with the same effects as in the fifteenth embodiment.

### Embodiment 16.

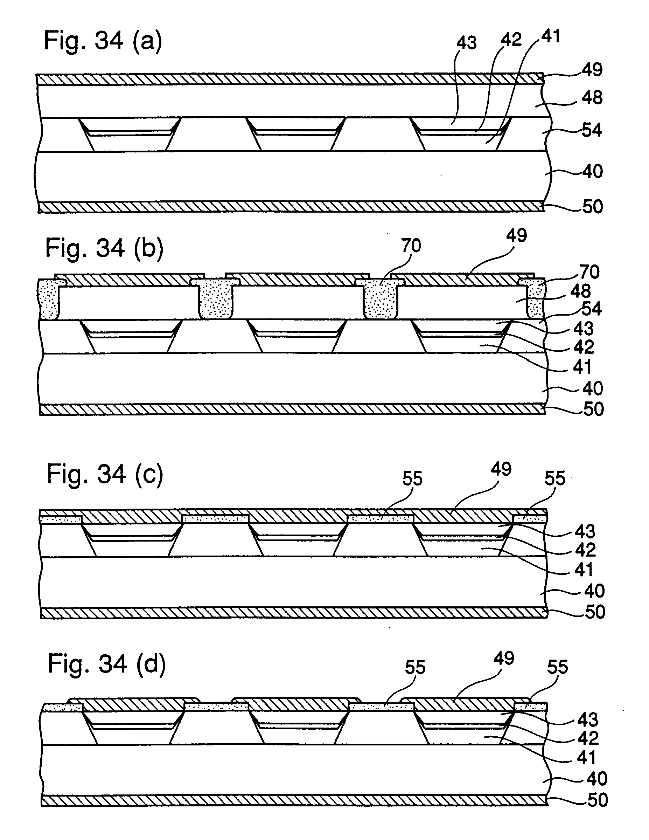

Figures 34(a)-34(d) are diagrams illustrating an array type semiconductor laser (hereinafter referred to as array laser) according to a sixteenth embodiment of the present invention. In the figures, the same reference numerals shown in figure 27 designate the same or corresponding elements. Reference numeral 70 designates an insulating film.

The array laser of this sixteenth embodiment has fabricated an array type semiconductor laser according to the fabricating method of a semiconductor laser according to a twelfth embodiment. Particularly, an Fe-InP blocking layer 54 is formed on the substrate 40, an insulating film 55 having stripe shaped apertures arranged in parallel with a predetermined interval are formed on the surface, the etching is performed using the thermal etching described in the first embodiment from the surface of the Fe.InP blocking layer up to reaching the substrate 40 in the MOCVD apparatus, the ambient in the MOCVD apparatus is replaced by the ambient for crystal growth without the wafer exposed to the external air, and the p type InP cladding layer 41, the InGaAsP active layer 42, and the n type InP contact layer 43 are selectively grown, thereafter, the insulating film is removed and the n type InP contact layer 48 is formed on the entire surface, an n side electrode 49 and a p side electrode 50 are respectively formed on the contact layer 48 and the rear surface of the substrate 1, whereby a laser array provided with a plurality of laser elements on the substrate 40 as shown in figure 34(a) is obtained with the same effects as in the twelfth embodiment.

In the sixteenth embodiment the contact layer 48 and the n side electrode 49 of the array laser are formed integrated with each other without being separated to respective laser elements. It may be that as shown in figure 34(b), after forming the contact layer 48 similarly as in the sixteenth embodiment, a stripe shaped groove reaching the insulating film 54 is formed on the contact layer 48 on the insulating film 54, and the insulating film 70 such as SION is formed so as to bury the same, thereby providing the contact layers 48 for respective laser elements, and the n side electrode 49 is provided on the contact layer 48 at a region put between the insulating film 70. In such case, n side electrodes 49 dependent for respective laser elements are formed, whereby it is possible to control the respective laser elements independently.

In addition, in the sixteenth embodiment, it may be that after selectively growing the n type InP cladding layer 43, the n side electrode 49 is formed on the entire surface without removing the insulating film 55 used for the selective growth, thereby resulting in an array laser of a structure as shown in figure 34(c).

In addition, in the sixteenth embodiment, it may be that after selectively growing the n type InP cladding layer 43, the n side electrode 49 is formed so as to bury the aperture of the insulating film 55, thereby forming the array laser of the structure shown in figure 34(d), with the same effects as in the sixteenth embodiment and respective laser elements can be controlled independently.

Here, in the above-described sixteenth embodiment, an array type laser is formed using the fabricating method of a semiconductor laser described in the twelfth embodiment. A description is given of an alternative in which an array type semiconductor laser is formed using the fabricating method of a semiconductor laser described in the eleventh embodiment.

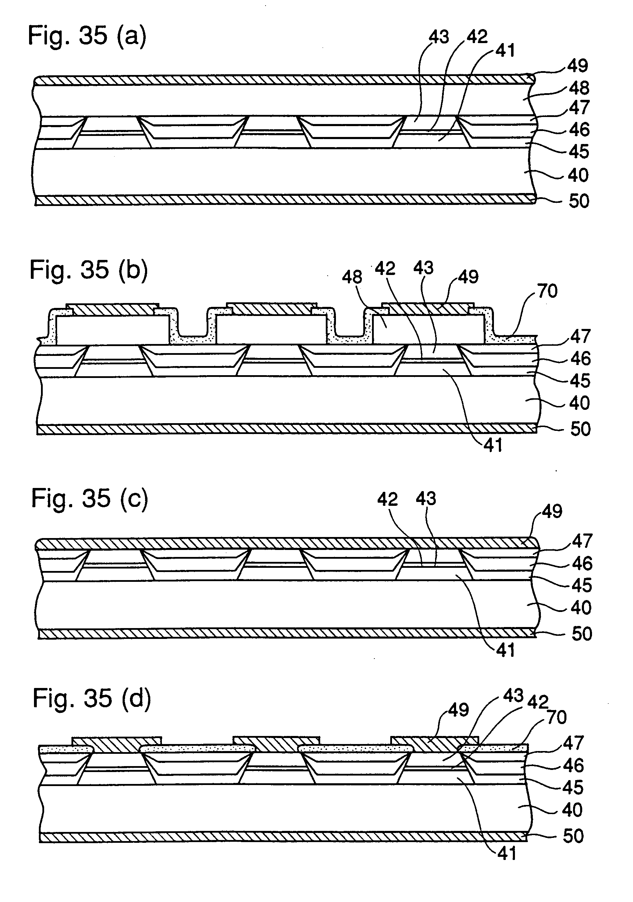

Figures 35(a)-35(d) are diagrams for illustrating alternatives of the sixteenth embodiment in which the same reference numerals as in figures 23 and 34 designate the same or corresponding elements.

The array laser shown in figure 35(a) has integrated the semiconductor lasers described in the twelfth embodiment in an array, and after forming the p type InP cladding layer 41, the active layer 42, and the n type InP cladding layer 43, a plurality of stripe shaped insulating films extending in the resonator length direction and arranged in parallel with each other with predetermined intervals are formed on the n type InP cladding layer 43, and thereafter, the fabricating method the same as that for the semiconductor laser of the eleventh embodiment are performed, with the same effects as in the eleventh embodiment obtained.

As another alternative of this sixteenth embodiment, as shown in figure 35(b), after forming the contact layer 48 similarly as in the sixteenth embodiment, a stripe shaped groove reaching the second stripe shaped groove reaching the second p type InP blocking layer 47 is formed, an insulating film 70 is formed so as to bury the same, and an n side electrode 49 is formed on the contact layer 48 at a region put between by the insulating films 70, and also in this case, the respective laser elements can be controlled independently.

As a still another alternative of this sixteenth embodiment, the n side electrode 49 may be formed on the second p type InP blocking layers 47 and the ridge stripe without providing the contact layer 48, thereby forming an array laser having a structure as shown in figure 35(c).

As a yet another alternative of this sixteenth embodiment, after selectively growing the second p type InP blocking layer 47, the stripe shaped insulating film mask used for forming a ridge is removed, the insulating film 70 is formed on the second current blocking layer 47, and the n side electrode 49 is formed so as to bury the aperture of the insulating film 70, thereby forming an array laser having a structure as shown in figure 35(d).

### Embodiment 17.

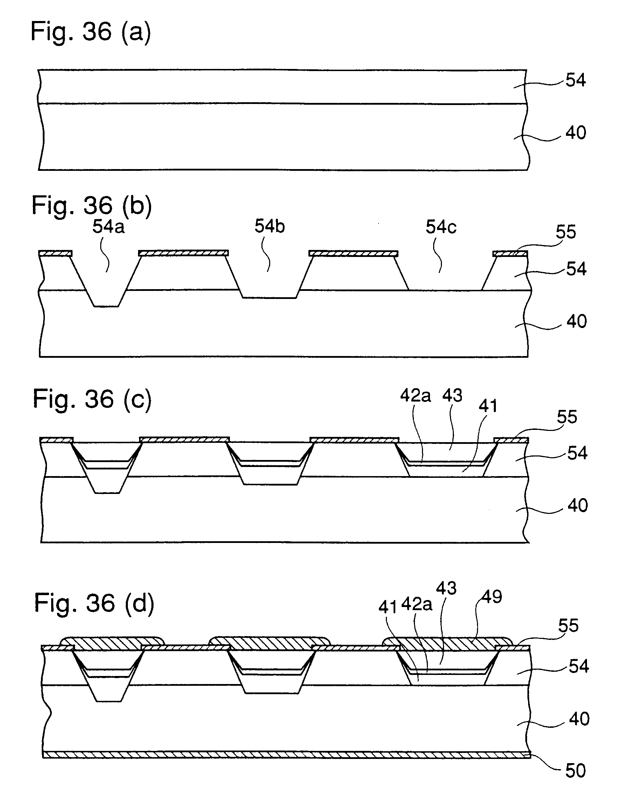

Figures 36(a)-36(d) are diagrams for illustrating a fabricating method of an array type laser according to a seventeenth embodiment of the present invention. The array laser of this embodiment is an array laser provided with laser elements having different wavelengths, and it is fabricated by the similar method as the sixteenth embodiment.

In the figures, the same reference numerals as in figures 27 designate the same or corresponding elements. Numeral 42a designates an active layer of a multi-quantum well structure constituted by well layers and barrier layers both comprising InₓGa₁-ₓxAsyP₁-y layers. Numerals 54a, 54b, and 54c designate portions of a plurality of apertures having different aperture widths formed in the insulating film 55 where the aperture width of the aperture 54a is narrowest and the aperture width of the aperture 54b is widest.

A description is given of the operation. First of all, as shown in figure 36(a), an Fe-In current blocking layer 54 is formed on the InP substrate 40, and an insulating film mask 55 having a plurality of stripe shaped apertures extending in the [01̅1̅] direction having different aperture widths is formed.

Next, using the insulating film 55 as a mask, the current blocking layer 54 is etched by the thermal etching described in the first embodiment up to reaching the InP substrate 40. Then, as described in the first embodiment using figure 4, because as the aperture width of the mask is narrow, the etching depth is deep, the depth of the mesa groove formed in the aperture 54a becomes deeper and the depth of the mesa groove formed in the aperture 54c becomes the shallowest.

Further, as shown in figure 36(c), the p type InP cladding layer 41, the multi-quantum well active layer 42a, and the n type InP cladding layer 43 are formed so as to bury the mesa groove formed by the etching. Here, when the crystal growth is performed by MOCVD, the crystal growth speed in the aperture having a wide aperture width is slow and that in the aperture having a narrow aperture width is fast. Therefore, the crystal growth speed in the mesa groove formed by the thermal etching at a portion of shallow etching depth with a wide aperture width is slow while that at a portion of deep etching depth with a narrow aperture width is fast. In the apertures 54a, 54b, and 54c, the crystal growth speed onto the aperture 54a is the fastest, and the crystal growth speed onto the aperture 54c is the slowest. As a result, the height position of the active layer 42a formed in respective apertures with relative to the surface of the substrate 1 become approximately equal to each other. Accordingly, in the apertures 54a, 54b, and 54c, the thickness of the quantum well active layer 42 formed at the aperture 54a is the thickest and the thickness of the quantum well active layer 42 is the thinnest.

Thereafter, as shown in figure 36(d), an n side electrode 49is formed in the aperture of the insulating film mask 55, and a p side electrode 50 is formed at the rear surface of the substrate 1, thereby obtaining an array laser.

The array laser of this embodiment has the thicknesses of the well layers and barrier layers of the multi-quantum well active layer 42a of the respective laser elements which are different dependent on the widths of the apertures of the insulating film 55, and therefore, the wavelengths of the laser light emitted from the respective laser elements are different.

In this way, in the array laser of this embodiment, the thermal etching is performed using a mask having an aperture of different aperture width, and thereafter a double hetero structure is formed by crystal regrowth, whereby a laser element provided with a quantum well active layer having different aperture widths of the insulating film can be simultaneously formed, and the fabrication process of a laser array that can emit laser light of different wavelengths can be shortened.

### Embodiment 18.

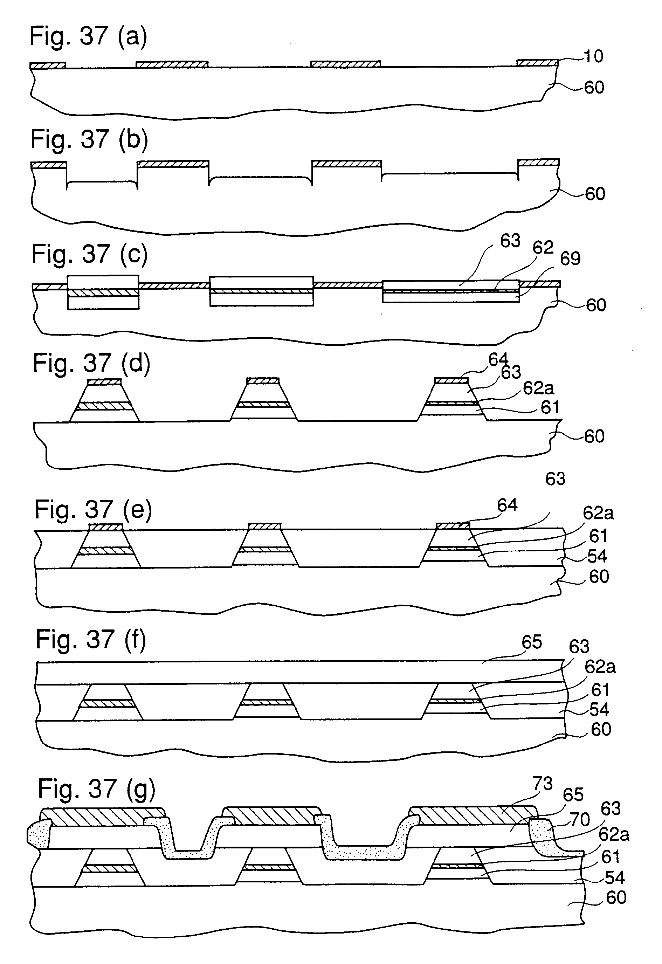

Figures 37(a)-37(g) are cross-sectional views illustrating a fabricating method of an array laser with a light modulator according to an eighteenth embodiment of the present invention. The array laser provided with light modulator of this eighteenth embodiment is an array laser with light modulator having a plurality of semiconductor laser devices each with light modulator having different wavelengths, and these are fabricated by the same methods as the fabricating method of the sixteenth embodiment. In the figures 37(a)-37(g), the same reference numerals as those in figures 32(a)-32(e) designate the same or corresponding elements. Reference numeral 62a designates a multi-quantum well active layer constituted by the barrier layers and well layers each comprising an InₓGa₁₋ₓAsyP_{1-y}, reference numeral 73 designates an n side electrode comprising Au series material formed at the semiconductor laser region. Reference numeral 54 designates an Fe-InP blocking layer, and reference numeral 70 designates an insulating film comprising such as SiON.

A description is given of the fabricating method. First of all, an insulating film mask 10 having a plurality of stripe shaped mask patterns having a narrow width opening aperture in the semiconductor laser region and a wide width aperture in the light modulator region which apertures are parallel with each other. Then, the aperture patterns are formed so that the aperture widths of the semiconductor laser regions are different from each other.

Next, after performing the thermal etching to the substrate 1 using the insulating film 10 as a mask similarly as in the fourteenth embodiment (figure 37(b)), the p type InP cladding layer 61, the quantum well active layer 62a, and the n type InP cladding layer 63 are formed. Then, the cross-section in the resonator length direction of the semiconductor laser region becomes similar as the cross-section configuration as shown in figure 31(d) as the fourteenth embodiment, and in the cross-section in the resonator width direction of the semiconductor laser region, the thicknesses of the well layers and the barrier layers of the active layer 62a formed at the aperture pattern having a narrow aperture pattern portion of the insulating film 10 become thick and the thicknesses of the well layers and the barrier layers of the active layer 62a formed at the aperture pattern portion having a wide aperture width are thin.

Thereafter, similarly as in the fourteenth embodiment, after the removal of the insulating film 10, the stripe shaped insulating film 64 is formed, and the thermal etching or wet etching is performed up to reaching the substrate 1 using the insulating mask as a mask, and as shown in figure 37(d), a mesa stripe is formed, a Fe-InP current blocking layer 54 is formed so as to bury the mesa stripe, the insulating film 64 is removed, and further, the n type InP contact layer 65 is formed on the blocking layer 54 and on the n type InP cladding layer 63.

Thereafter, the contact layer 65 between the respective mesa stripes are etched to be removed up to reaching the blocking layer 54 to form grooves, and an insulating film 70 is formed so as to bury the grooves, thereby separating the contact layer 65 corresponding to respective mesa stripes. Thereafter, a p side electrode (not shown) is formed on the rear surface side of the substrate 1, an electrode 73 is formed on the surface of the contact layer 65 at the semiconductor layer region and an electrode (not shown) is formed on the surface of the contact layer 65 at the light modulator region, thereby obtaining an array laser with light modulator comprising a plurality of laser elements provided with light modulator as shown in figure 37(g).

In this eighteenth embodiment, since the thicknesses of the well layers and barrier layers of the active layer 62a of the semiconductor laser region of the respective laser element with light modulator, the wavelength of the light that is emitted from the semiconductor laser region of respective laser element provided with light modulator become different ones, as a result, an array laser provided with a light modulator that can emit laser light of different wavelengths can be obtained.

As described above, in the array laser provided with light modulator according to this eighteenth embodiment, the thermal etching is performed using a maskprovided with a plurality of apertures having different aperture widths, and a doublehetero structure is crystalline regrown to form a laser array comprising a plurality of laser elements provided with light modulator, the plurality of laser elements provided with light modulator having quantum well active layers having thicknesses different dependent on the widths of the apertures of the insulating film, thereby shortening the fabricating process of a laser array with light modulator that can emit a plurality of different wavelengths.

In the above-described sixteenth to eighteenth embodiments, a description is given of semiconductor lasers, but the present invention can be also applied to semiconductor devices other than semiconductor lasers with the same effects obtained.

### Embodiment 19.

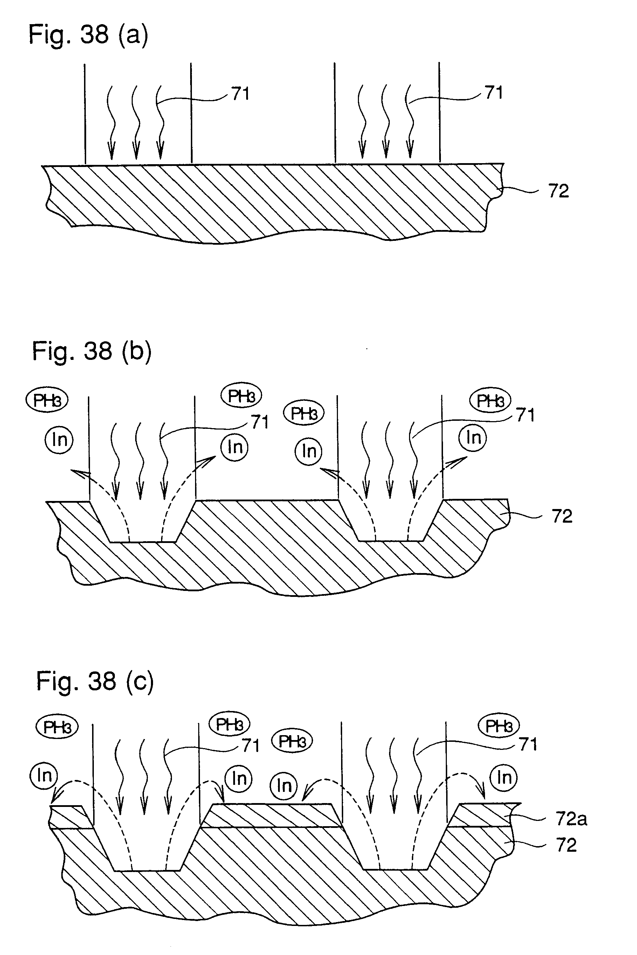

Figures 38(a)-38(c) are diagrams illustrating a semiconductor etching method according to a nineteenth embodiment of the present invention. In the figures, reference numeral 71 designates a visible light, numeral 72 designates an InP substrate, numeral 72a designates an InP regrowth layer.

A description is given of a semiconductor etching method. First of all, the InP substrate 72 is kept in an ambient in which only the substrate temperature that the substrate temperature is set at a temperature lower than the temperature at which InP is etched on the same condition as that described in the first embodiment. Next, as shown in figure 38(a), the visible light is irradiated only to the region on the substrate 72 which is to be etched. Then, the portion to which the light is irradiated reaches the temperature at which the thermal etching is possible and among the substrate 72, only the InP of the region to which the light is irradiated is heated and it is selectively etched (figure 38(b)).

As described above, in this nineteenth embodiment, the thermal etching described in the first etching and the light irradiation are combined, and only the region to which the light of the surface of the InP layer surface is heated, and the heated region is etched, whereby the InP layer can be easily selectively etched without using a selective mask such as an insulating film.

In the above-described nineteenth embodiment, a visible light is used but the infrared light or ultraviolet light may be employed with the same effects as in the nineteenth embodiment.

In the above-described nineteenth embodiment, when the temperature of the substrate 1 is made a temperature that is lower than the temperature at which InP is etched and capable of growing InP, and the energy of the irradiated light is increased in the irradiation, at the region where light is irradiated InP is etched and the etched In is diffused into the vapor phase as shown in figure 38(c). By that the In atoms diffuses to a portion where the light is not irradiated to react with PH₃ in the etching ambient, the InP layer 72a can be regrown, whereby the selective etching and the selective growth can be performed at the same time.

In the above-described nineteenth embodiment, it is described a case in which the thermal etching described in the first embodiment is used, the present invention can be applied to a case where the usual vapor phase etching using a halogen series gas, and even in this case, when the light is irradiated, that portion receives the energy of the light a lot to be likely to react with halogen gas such as HCl, whereby a selective etching of the region to which light is irradiated is made possible.

### Embodiment 20.

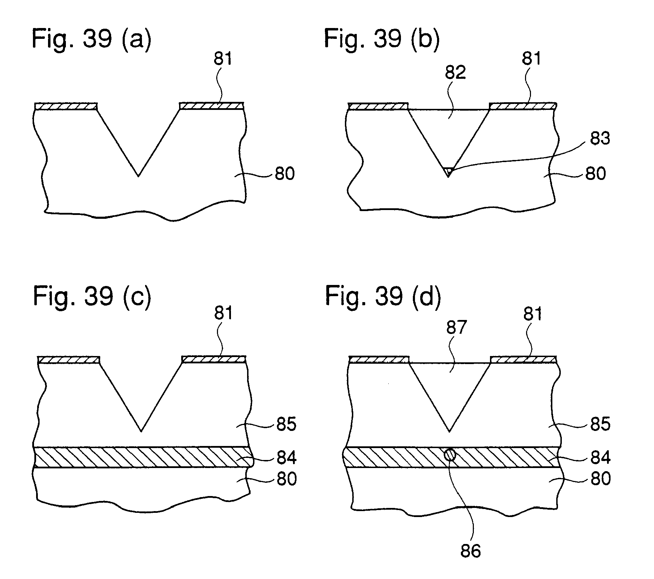

Figures 39(a)-39(d) are cross-sectional views illustrating a main process step of a fabricating method of a quantum wire structure using the thermal etching described in the first embodiment. In the figures, numeral 80 designates an InP substrate, numeral 81 designates an insulating film pattern, numeral 82 designates an InP burying layer, numeral 87 designates an n type InP burying layer, numeral 83 designates an InGaAs electron running layer, numeral 84 designates an i type InGaAs electron running layer, and numeral 85 designates an electron storage part.

A description is given of the fabricating method. First of all, an insulating film 81 is formed on the (100)just plane of the InP substrate 80, and a stripe shaped insulating aperture extending in the [01̅1̅] direction is formed in the insulating film 81 by photolithography. Thereafter, a V shaped groove having side surfaces of (111) plane is formed using the thermal etching described in the first embodiment.

Next, an InGaAs electron supplying layer 83 is grown to a thickness below 10 nm at the bottom of the V shaped groove. Then, since the side surface of the V shaped groove is (111) plane, the InGaAs layer 83 hardly grows thereon. Further, the InP burying layer 82 is grown on the InGaAs layer 83. By the above-described process, a quantum wire structure comprising the InGaAs layer 83 surrounded by the InP substrate 80 and the InP burying layer 82 are formed.

In this twentieth embodiment of the present invention, since the V shaped groove is formed by using the thermal etching of the first embodiment, a quantum wire can be formed with high controllability.

While in the above-described twentieth embodiment, InGaAs is used as a material of a portion where a quantum well is formed, the present invention can employ any material which can be employed for the usual quantum wire such as AlInAs.

In the above-described twentieth embodiment a case in which a quantum wire is formed is described. However, it is possible to integrate a plurality of quantum wires on a substrate. An alternative of the twentieth embodiment which forms a plurality of quantum wires integratedly on a substrate will be described.

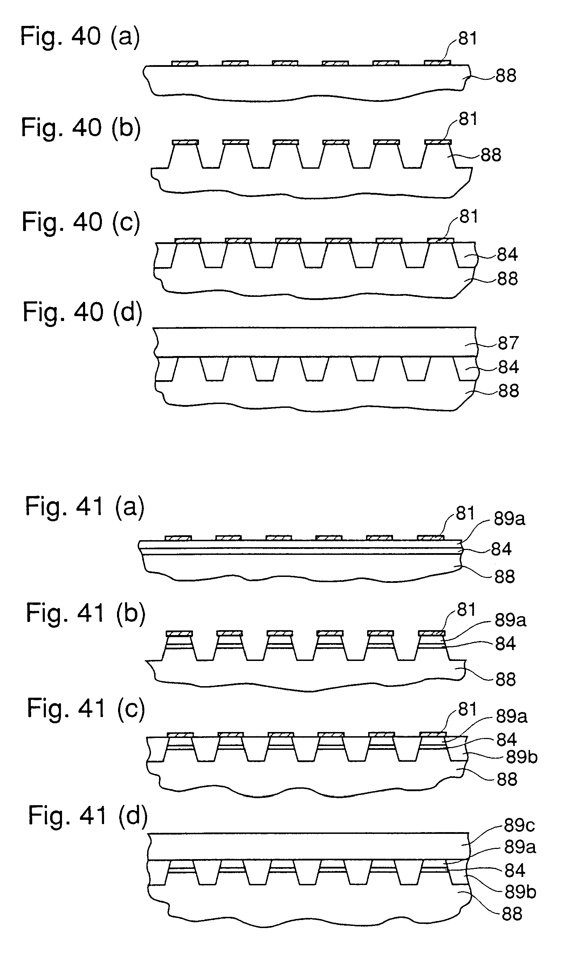

Figure 40 is a diagram illustrating an alternative of the twentieth embodiment of the present invention. In the figures, reference numeral 39 designates the same or corresponding elements. Numeral 88 designates a p type InP substrate, and numeral 89 designates an n type InP layer.

A description is given of the fabricating method. First of all, an insulating film 81 is formed on the (100) surface of the p type InP layer, and a minute pattern in which a plurality of apertures having a width of about 20 nm are arranged with an interval of 20 nm are formed using the method of EB (electron beam) method, FIB (focused ion beam method), interference exposure method, and phase shifting exposure method. Next, by the thermal etching using the insulating film 81 as a mask, a groove having a (111) surface at the side surfaces are formed. Thereafter, the i type InGaAs electron running layer 84 is selectively grown so as to bury the groove and after the removal of the mask 81, the n type InP layer 87 is formed to form a quantum wire comprising the InGaAs layer 8.

In the alternative of this twentieth embodiment, the same effects as in the twentieth embodiment are obtained and the quantum wire can be easily integrated.

In this alternative, after the substrate 88 is thermally etched, the i type InGaAs layer 84 which would serve as the quantum wire is formed buryingly. However, as shown in figure 41 (a), it may be that the i type InGaAs layer 84 and the first n type InP layer 89a are formed on the substrate 11, and an insulating film 81 having a fine pattern of a width of about 20 nm on the surface are formed, the thermal etching is performed until reaching the substrate 88 using this as a mask, the etching groove is buried with the second n type InP layer 89b, and after the removal of the insulating film 81, the third n type InP layer 89c may be formed on the surface of the first n type InP layer 89a and the surface of the first n type InP layer 89c. Then, in the figures 41, the reference numerals the same as in the figures 40 designate the same or corresponding elements. Numeral 89a, 89b and 89c designate the first, the second, and the third n type InP layers. In such case, the same effects as in the twentieth embodiment will be obtained.

In the semiconductor devices such as semiconductor laser devices as illustrated in the first to twelfth embodiments, the fourteenth embodiment, the sixteenth to eighteenth embodiment, InP is used as a material for the contact layer. In order to take an easy contact with the electrode, an InGaAs contact layer may be laminated on the InP contact layer.

Further, in the above-described embodiment, a case in which the thermal etching method is applied to an InP series material is described. The present invention can be applied to a case where the thermal etching is performed to other III-V group compound semiconductor material. For example, when the thermal etching is performed to GaAs, it may be that AsH₃ gas is supplied in place of PH₃ to perform an etching at a higher temperature than the growth temperature of GaAs, and when the III-V group compound semiconductor other than GaAs is etched, the etching may be performed at a higher temperature than the growth temperature of the III-V group compound semiconductor. In such case, the same effects as in the respective embodiments are obtained.

## Claims

1. An etching method for semiconductor comprising:
etching a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor.

2. The etching method of claim 1, wherein;
the III group gas forming said III-V group compound semiconductor layer is added to said etching gas thereby to control the etching characteristics of said etching.

3. The etching method of claim 1, wherein;
said III-V group compound semiconductor layer is an InP layer, and said etching is carried out by using a gas including phosphorus gas.

4. The etching method of claim 1, wherein said III-V group compound semiconductor layer is an InP layer, and said etching is carried out by keeping said InP layer at above 700 °C.

5. The etching method of claim 1, wherein said III-V group semiconductor layer is an InP layer, and said etching is carried out by keeping said InP layer at above 700 °C, using PH₃ gas of flow rate of 400 SCCM and H₂ gas of flow rate of 25 SCCM as etching gases and keeping the pressure in the reaction apparatus at a 30 Torr.

6. The etching method of claim 1, further comprising:
forming an insulating film provided with a stripe shaped aperture comprising a plurality of regions having different aperture widths on a main surface of said III-V group compound semiconductor layer; and
selectively etching said III-V group compound semiconductor layer using said insulating film as a mask.

7. The semiconductor etching method of claim 1, further comprising:
forming an insulating film provided with a stripe shaped aperture of a predetermined width and having a plurality of regions having different widths in the stripe direction of said aperture portion;
selectively etching said III-V group compound semiconductor layer using said insulating film as a mask.

8. An etching method for semiconductor comprising:
selectively etching only a prescribed region of the surface of said III-V group compound semiconductor layer with keeping said III-V group compound semiconductor layer under an ambient where an etching gas including V group gas constituting said III-V group compound semiconductor layer is supplied and heating said prescribed region.

9. The semiconductor etching method of claim 8, wherein,
said etching is carried out with holding said III-V group compound semiconductor layer at a temperature at which crystal growth of said III-V group compound semiconductor is possible.

10. A method for fabricating a semiconductor device, comprising:
forming an insulating film having an aperture on a main surface of a III-V group compound semiconductor layer;
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor; and
growing another semiconductor layer using said insulating film as a mask with replacing the etching gas used for said etching by a crystal growth gas without said III-V group compound semiconductor layer being exposed to the external air.

11. A method for fabricating a semiconductor device, comprising:
forming an insulating film having an aperture on a main surface of a first conductivity type III-V group compound semiconductor layer;
selectively etching said first conductivity type III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor; and
selectively growing a double-hetero structure comprising a first conductivity type cladding layer, an active layer, and a second conductivity type clad-ding layer successively using said insulating film as a mask with replacing the etching gas used for said etching by a crystal growth gas without said III-V group compound semiconductor layer being exposed to the external air.

12. A method for fabricating a semiconductor device, comprising:
forming an insulating film having an aperture on a main surface of a III-V group compound semiconductor layer;
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor; and
selectively growing a multi-quantum well structure layer using said insulating film as a mask with replacing the etching gas used for said etching by a crystal growth gas without said III-V group compound semiconductor layer being exposed to the external air.

13. A method for fabricating a semiconductor device, comprising:
forming an insulating film having plurality of stripe shaped apertures arranged in parallel with each other;
selectively etching said III-V group compound semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor.

14. The method for fabricating a semiconductor device of claim 13, wherein,
said plurality of stripe shaped apertures have a stripe length for a prescribed region different from the stripe length of other region.

15. The method for fabricating a semiconductor device of claim 13, wherein,
said plurality of stripe shaped apertures have stripe lengths mutually equal to each other, and
said insulating film is formed to have a width in the direction perpendicular to the arranging direction of said apertures that is narrower than the width of the other region.

16. The method for fabricating a semiconductor device of claim 13, further comprising:
after selectively etching said III-V group compound semiconductor layer, growing another semiconductor layer using said insulating film with replacing the etching gas by a crystal growth gas without said III-V group compound semiconductor layer being exposed to the external air.

17. A method for fabricating a semiconductor layer, comprising:
forming a current blocking layer comprising a III-V group compound semiconductor material on a main surface of a first conductivity type III-V group compound semiconductor substrate;
forming an insulating film having a stripe shaped aperture on the surface of said current blocking layer;
forming a stripe shaped groove by selectively etching said current blocking layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a stripe shaped groove; and
selectively growing a double-hetero structure comprising a first conductivity type cladding layer, an active layer, and a second conductivity type cladding layer using said insulating film as a mask with replacing said etching gas used for said etching without the surface of said stripe shaped groove being exposed to the outside air.

18. A method for fabricating a semiconductor laser, comprising:
forming a double-hetero structure comprising a first conductivity type cladding layer, an active layer, and a second conductivity type cladding layer on a main surface of a first conductivity type III-V group compound semiconductor substrate;
forming a stripe shaped insulating film on said double-hetero structure, and forming a mesa stripe by selectively etching said double-hetero structure up to reaching said substrate using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a mesa stripe; and
selectively growing a current blocking layer so as to bury said mesa-stripe, using said insulating film as a mask with replacing said etching gas used for said etching without the surface of said stripe shaped groove being exposed to the outside air.

19. A method for fabricating a semiconductor laser, comprising:
forming a current blocking layer comprising a III-V group semiconductor material on a main surface of a first conductivity type III-V group compound semiconductor substrate;
forming an insulating film having a plurality of stripe shaped apertures mutually parallel and having a different aperture width on the surface of the current blocking layer;
forming a stripe shaped grooves by selectively etching said current blocking layer up to reaching said substrate using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a plurality of stripe shaped grooves; and
selectively growing a double-hetero structure comprising a first conductivity type cladding layer, a multi-quantum well structure active layer, and a second conductivity type cladding layer, using said insulating film as a mask with replacing said etching gas used for said etching without the surface of said stripe shaped groove being exposed to the outside air.

20. A method for fabricating a semiconductor laser device, comprising:
forming a first insulating film having a plurality of striped shaped apertures mutually parallel having different aperture widths on a main surface of a first conductivity type III-V group compound semiconductor substrate;
selectively etching said III-V group compound semiconductor substrate using said first insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a plurality of stripe shaped grooves;
selectively growing a double-hetero structure comprising a first conductivity type cladding layer, a multi-quantum well structure active layer, and a second conductivity type cladding layer, using said first insulating film as a mask with replacing said etching gas used for said etching without the surface of said stripe shaped groove being exposed to the outside air, so as to bury said plurality of stripe shaped grooves; and
after removing said first insulating film, forming a stripe shaped second insulating film extending in the length direction of said double-hetero structure on said double-hetero structure, and etching said double-hetero structure using said second insulating film as a mask, thereby to form a mesa-stripe; and
forming a current blocking layer so as to bury said mesa-stripe using said second insulating film as a mask.

21. A method for fabricating a semiconductor laser, comprising:
forming an insulating film having a stripe shaped aperture on a main surface of a first semiconductor layer comprising a III-V group compound semiconductor;
selectively etching said III-V group compound semiconductor substrate using said stripe shaped insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, to form a plurality of stripe shaped grooves;
selectively growing an electron running layer at the bottom of said stripe shaped groove using said insulating film with replacing said etching gas by crystal growth gas without the surface of said stripe shaped V shaped groove being exposed to the external air; and
after said selective growth, selectively growing a second III-V group compound semiconductor layer comprising the same material as that of said first semiconductor layer so as to bury said stripe shaped V shaped groove using said insulating film.

22. A method for fabricating a semiconductor device, comprising:
forming an electron running layer comprising an intrinsic semiconductor layer and a second semiconductor layer comprising an intrinsic III-V group compound semiconductor layer electron running layer on a main surface of a first semiconductor layer;
forming an insulating film having a stripe shaped aperture on the surface of said second semiconductor layer;
etching said second semiconductor layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor up to a depth not reaching said electron running layer, to form a stripe shaped V-shaped groove;
selectively growing a third III-V group compound semiconductor layer having a prescribed conductivity type comprising the same material as that of said first semiconductor layer so as to bury said V-shaped groove using said insulating film with replacing said etching gas by crystal growth gas without the surface of said second semiconductor layer being exposed to the external air.

23. A semiconductor laser comprising:
a III-V group compound semiconductor layer having a groove on its main surface comprising a plurality of regions having different aperture widths and the depth of the wide aperture width region is deeper than the depth of the narrow aperture width region;
a double-hetero structure layer including a multi-quantum well structure layer formed so as to bury said stripe shaped groove, having a thickness thinner than the thickness of the narrow aperture width region in the wide aperture width region and having a height with relative to the main surface of the III-V group compound semiconductor layer which is equal over the entire surface.

24. A semiconductor laser, comprising:
a first conductivity type III-V group compound semiconductor substrate;
a current blocking layer comprising a III-V group compound semiconductor material formed on a main surface of said first conductivity type III-V group compound semiconductor substrate;
a plurality of stripe shaped grooves formed by forming a plurality of stripe shaped apertures having different aperture widths and mutually parallel on the surface of the current blocking layer and selectively etching said current blocking layer using said insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor up to reaching said substrate; and
a double-hetero structure comprising a first conductivity type cladding layer, a multi-quantum well structure active layer, and a second conductivity type cladding layer which are selectively grown so as to bury said stripe shaped groove, with replacing said etching gas used in said etching by crystal growth gas without the surfaces of said plurality of stripe shaped grooves being exposed to the external air.

25. A semiconductor laser, comprising:
a first conductivity type III-V group compound semiconductor substrate;
a plurality of mesa-stripes which are formed by:
forming a first insulating film having a plurality of stripe shaped openings having different widths mutually parallel on a main surface of said first conductivity type III-V group compound semiconductor substrate,
selectively etching said III-V group compound semiconductor substrate using said first insulating film as a mask by an etching method for semiconductor, that etches a III-V group compound semiconductor using an etching gas including V group material forming said III-V group compound semiconductor layer and keeping said III-V group compound semiconductor layer at a temperature higher than the temperature of the crystal growth temperature of said III-V group compound semiconductor, thereby to form a plurality of stripe shaped grooves,
selectively growing a double-hetero structure comprising a first conductivity type cladding layer, a multi-quantum well structure active layer, and a second conductivity type cladding layer so as to bury said plurality of stripe shaped grooves, with replacing said etching gas used in said etching by crystal growth gas without the surfaces of said plurality of stripe shaped grooves being exposed to the external air,
after removing said first insulating film, forming a stripe shaped second insulating film extending in the length direction of said double hetero structure on said double hetero structure, and etching said double-hetero structure using said second insulating film as a mask; and
a current blocking layer formed so as to bury said mesa-stripe using said second insulating film as a mask.
